(19) Europäisches Patentamt
European Patent Office
Office européen des brevets

(11) EP 0 512 677 B1

(12) **EUROPEAN PATENT SPECIFICATION**

(45) Date of publication and mention of the grant of the patent:
**24.11.1999 Bulletin 1999/47**

(51) Int Cl.[6]: **H01J 37/32**

(21) Application number: **92302728.8**

(22) Date of filing: **27.03.1992**

(54) **Plasma treatment method and apparatus**

Verfahren und Vorrichtung zur Plasmabehandlung

Méthode et appareil pour le traitement par plasma

(84) Designated Contracting States:
**DE FR GB**

(30) Priority: **04.04.1991 JP 7146491**
**13.01.1992 JP 367592**

(43) Date of publication of application:
**11.11.1992 Bulletin 1992/46**

(73) Proprietor: **HITACHI, LTD.**
**Chiyoda-ku, Tokyo (JP)**

(72) Inventors:
- **Kumihashi, Takao**
  **Kokubunji-shi, Tokyo (JP)**
- **Tsujimoto, Kazunori**
  **Higashi-yamamoto-shi, Tokyo (JP)**
- **Tachi, Shinichi**
  **Sayama-shi, Saitama (JP)**
- **Kanetomo, Masafumi**
  **Suginami-ku, Tokyo (JP)**
- **Kobayashi, Junichi**
  **Ushiku-shi, Ibaraki (JP)**
- **Usui, Tatehito**
  **Niihara-gun, Ibaraki (JP)**
- **Mise, Nobuyuki**
  **Niihara-gun, Ibaraki (JP)**

(74) Representative:
**Paget, Hugh Charles Edward et al**
**MEWBURN ELLIS**
**York House**
**23 Kingsway**
**London WC2B 6HP (GB)**

(56) References cited:
**EP-A- 0 272 140** **EP-A- 0 407 169**
**US-A- 4 339 326** **US-A- 4 462 863**
**US-A- 4 842 683** **US-A- 4 985 109**

- **JOURNAL OF VACUUM SCIENCE AND TECHNOLOGY: PART B vol. 8, 1990, NEW YORK US pages 1185 - 1191 S.C. MCNEVIN 'RADIO FREQUENCY PLASMA ETCHING OF SI/SI02 BY CL2/02: IMPROVEMENTS RESULTING FROM THE TIME MODULATION OF THE PROCESSING GASES'**
- **JOURNAL OF VACUUM SCIENCE AND TECHNOLOGY: PART A vol. 6, no. 4, 1988, NEW YORK US pages 2348 - 2352 CHIHARU TAKAHASHI ET AL. 'AN ELECTRON CYCLOTRON RESONANCE PLASMA DEPOSITION TECHNIQUE EMPLOYING MAGNETRON MODE SPUTTERING'**
- **PATENT ABSTRACTS OF JAPAN vol. 15, no. 219 (E-1074)5 June 1991 & JP-A-03 062 517 ( ANELVA CORP. ) 18 March 1991**
- **PATENT ABSTRACTS OF JAPAN vol. 14, no. 218 (E-925)9 May 1990 & JP-A-02 052 428 ( TOKYO ELECTRON ) 22 February 1990**
- **MICROELECTRONIC ENGINEERING vol. 9, 1989, AMSTERDAM NL pages 481 - 484 K. NISHIOKA ET AL. 'EFFECTS OF PLASMA PARAMETERS ON ETCHING CHARACTERISTICS WITH ECR PLASMA'**
- **EXTENDED ABSTRACTS OF THE 22ND (1990 INTERNATIONAL) CONFERENCE ON SOLID STATE DEVICES AND MATERIALS, Sendai, pages 207-210**
- **D. WIDMANN ET AL., "TECHNOLOGIE HOCHINTEGRIERTER SCHALTUNGEN" (Halbleiter-Elektronik, vol. 19), 1988, Springer-Verlag, Berlin, DE, pages 193-207**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 512 677 B1

- **S.M. SZE, VLSI TECHNOLOGY", 2nd edition, 1988, McGraw-Hill Book Company, New-York, US, pages 212-220**
- **JAPANESE JOURNAL OF APPLIED PHYSICS, vol. 29, no.4, April 1990, pages 792-797**


Remarks:

The file contains technical information submitted after the application was filed and not included in this specification

## Description

The present invention relates to a plasma etching method, specifically a dry etching method suitable for fabricating for example fine and deep grooves and holes.

The dry etching technique permits easy microfabrication when compared with the wet etching techniques that uses chemical solutions, and thus has found wide use in the manufacture of large-scale integrated circuits (LSIs). A conventional reactive ion etching (RIE) method requires a gas pressure of 10 mTorr and a reaction gas flow of 10 sccm to 100 sccm for a gas etching process. In this specification pressure is given in Torr or mTorr. 1 Torr equals 133 Pa. "sccm" is standard cubic centimetres per minute", i.e. volume at 0°C and atmospheric pressure. In the RIE method, a lower gas pressure than the lower limit results in unstable discharges and a higher gas pressure than the upper limit results in isotropic etching. In conventional dry etching machines, pumps with an evacuation rate of less than 1,000 l/s are often used and the reaction gas flow is chosen from a range of values that allows the setting of the above gas pressure.

JP-A-126174/1977 and Extended Abstracts of the 22nd International Conference on Solid State Devices and Materials, Sendai 1990, p207, disclose a microwave plasma etching (ECR) technique which shows the features of the first part of present claim 1. Further, Dry Process Symposium, 1988, p54, and Journal of Vacuum Science Technology 1991, B9(2), 310, describe dry etching machines for magnetron discharge RIE and helical resonator discharge RIE, respectively. These dry etching machines have a reaction gas pressure of more than 0.5 mTorr and the gas flow of less than 20 sccm. The etching speed achieved by these devices is about 300 nm/min in the case of ECR etching with a polycrystalline silicon used as the material to be etched, a chlorine gas ($Cl_2$) as a reaction gas, a gas pressure at 0.5 mTorr and a gas flow at 20 sccm. Jap. J. Appl. Phys., vol. 29, no. 4, April 1990, 792-797, discloses polyimide film etching with $O_2/SF_6$ mixture gas plasma not forming the sidewall-protection film.

One example of the conventional dry etching machine is the microwave machine shown in Figure 16, which shows a microwave source 101, a waveguide 102, a gas inlet 104, gas piping 105, a gas flow rate controller 106, a solenoid coil 107 to increase the density of generated plasma, a wafer 109 and a sample stage 110. The pressure of the vacuum chamber 111 is lowered by a vacuum pump 114. There is also an RF power supply 112 connected to the stage 110. The discharge zone is at 117. Microwaves generated by the microwave source 101 are introduced through the waveguide 102 into the discharge zone 117 where the reaction as is converted into plasma, which in turn etches the surface of the wafer 109 placed on the sample stage 110. In this dry etching machine one kind of gas is introduced into the discharge zone 117 through one gas piping 105 and one gas flow rate controller 106. The gas piping 105 is directly connected to the discharge zone 117. The open area of the gas inlet 104 is about the same as the cross section of the gas piping 105. The gas pressure in the vacuum chamber 111 rises as the flow rate of the reaction gas increases, and is reduced as the effective speed of evacuating the vacuum chamber 111 by the vacuum pump 114 increases. For a gas pressure of more than 1 mTorr, the gas flow rate is set at several tens of sccm; for a low gas pressure region at 0.1 mTorr, the flow rate is set at several sccm. The effective speed of exhaust is determined by the pumping speed of the vacuum pump 114 and the conductance of the evacuation system for the vacuum chamber 111. The conventional machine has an effective exhaust speed of 400 l/s or less.

The pressure in the vacuum chamber as related to the gas flow introduced is expressed as follows.

$$P = (q + Q)/S \qquad (1)$$

where P (Torr) represents the pressure in the vacuum chamber, q represents the leak rate from the equipment when no gas is introduced, Q represents the flow rate of gas introduced (Torr·l/s), and S represents the effective evacuation speed of the equipment (l/s). Normally, q is less than 1/1,000 of Q and almost negligibly small. The conventional machines have a turbomolecular pump with the exhaust speed ($S_0$) of about 1000 l/s or less and the exhaust conductance of the vacuum chamber (C) of between 200 l/s and 1,000 l/s. The effective speed of exhaust $S_o$ with a plurality n of pumps having exhaust speeds $S_l$ to $S_n$ is given by

$$l/S_o = l/\Sigma S_n + l/C \qquad (2)$$

The conventional machines have been able to perform evacuation at the effective exhaust speed of 100-400 l/s. Hence, the flow rate of gas that can be achieved when the gas pressure is set at 0.5 mTorr is 4-20 sccm.

The time that the gas stays in the vacuum chamber, a measure of ease with which the gas can flow in the vacuum chamber, is expressed by

$$\tau = V/X\ (=PV/Q) \qquad (3)$$

where V is the total volume of the vacuum chamber. In the conventional machines, since the effective gas exhaust rate is 100-400 l/s and the vacuum chamber volume is 100-300 1, the gas residence time is about 400 ms to 3 s.

As the LSIs become smaller and smaller, there are growing demands for development of a fabrication technology to form grooves and holes about 0.3 μm in size. With the dry etching using the conventional RIE, it is difficult to form fine grooves and holes with high precision because the high gas pressure causes scattering of ions in the gas plasma, disturbing the direction in which the ions strike the substrate.

By lowering the gas pressure in the vacuum chamber, it is possible to prevent the scattering of ions that are incident on the sample. To perform an anisotropic fabrication of grooves and holes of the above-mentioned size, it is necessary to limit the angle of incidence of ions striking the sample to less than 1 degree and the gas pressure in the vacuum chamber to less than 1 mTorr, preferably less than 0.5 mTorr. To keep the plasma discharge stable requires the pressure of at least 0.01 mTorr. The dry etching machines having low gas pressures include ECR etching machines, magnetron discharge RIE machines and helical resonator discharge RIE machines. The conventional dry etching machines, however, have a problem that lower gas pressure results in reduced etching rate. In other words, increasing the etching directionality and heightening the etching speed are two conflicting requirements and are difficult to meet at the same time.

The diameters of Si wafers for LSIs are increasing. The ECR etching machines use a single wafer system in which wafers are carried to the vacuum chamber one at a time for etching. With this equipment, it takes about 1 to 2 minutes to reduce the thickness of a six-inch (15 cm) polysilicon wafer by 200 nm at the etching speed of 200 to 300 nm/min. When an eight-inch (20 cm) wafer is used, the etching speed decreases due to an etching area dependency (so-called a loading effect), prolonging the processing time to 2 and 4 minutes and reducing the throughput rate. The throughput rate may be improved by raising the etching speed by increasing the input power of the high frequency or microwave. This, however, gives rise to another problem that an increased ion energy reduces the selectivity. While it is possible to improve throughput rate without changing the etching conditions by using a plurality of single-wafer-system dry etching machines for parallel processing, the equipment cost becomes prohibitively high.

The above ECR etching machines have another drawback. The cross-sectional area of the opening portion of the gas inlet is small. When the effective gas exhaust rate is set higher than that of the conventional machines to increase the flow rate of gas flowing in the vacuum chamber 111 to more than 1300 l/s for example, the velocity of the gas flowing from the gas inlet 104 into the vacuum chamber 111 rises to close to the speed of sound, causing shock waves in the flow, which in turn makes the pressure in the flow non-uniform. Under this condition, not only is the gas density over the sample not uniform, but the distribution of plasma produced by discharge becomes non-uniform and unstable, degrading the uniformity of the etching speed. Hence, the gas flow speed should be set to below the sonic speed or preferably one third the sonic speed.

In the equipment configuration where the gas inlet 104 is located near the side of the sample stage 110, which doubles as a gas outlet for the discharge zone 117, the gas flowing from the gas inlet 104 toward the discharge zone 117 is evacuated from the outlet before it can disperse in the entire space of the discharge zone 117. As a result, the gas is not effectively utilized. Moreover, depending on the shape of the discharge zone, the gas flow may fail to disperse sufficiently over the central area of the discharge zone 117.

Since only one gas flow rate controller 106 and one gas piping 105 are used for supplying one kind of gas, a deviation occurs with the gas flow in the discharge zone 117, reducing the uniformity of etching.

Still another problem with the conventional machines is that as the wafer diameter becomes large, it is increasingly difficult for the gas flow to disperse sufficiently to cover the central area of the discharge zone 117.

An object of this invention is to provide a plasma etching method that can etch fine grooves and holes with high precision e.g. high anisotropy and high etching rate.

Another object of the invention, at least in some embodiments, is to provide a plasma etching method having a high throughput rate.

Another object of this invention, at least in some embodiments is to provide a plasma etching method in which there is less contamination due to re-adhesion of reaction products on wafer surfaces and the treatment chamber's inner walls.

According to the invention, there is provided a plasma etching method as set out in claim 1. Preferably, the gas pressure in the vacuum treatment chamber is 5 mTorr or less, e.g. 1 mTorr or less; and preferably the reaction gas residence time is 300 ms or less more preferably 100 ms sec or less at 1300 l/sec or more effective exhaust speed.

Fig. 33 shows relations of exhaust speed, gas pressure regulating range and effectiveness in this invention. As mentioned before, gas pressure is the parameter which regulates the etching directional property (anisotropy) while the exhaust speed is the parameter which regulates etch speed. Previously in etching, exhaust speeds were low, with effective exhaust speeds of about 400 l/sec or below, so that even if high density plasma etching devices, such as a microwave etching device, were used, there was a problem of low etch speed; and high anisotropic processing was in fact difficult, because the selection ratio to the mask was small, even when the incident particle's directional property was orderly at low gas pressures.

The major scope of application of this invention can be divided into three areas, as shown in Fig. 33 These areas are: (1) to increase etch speed - regardless of the gas pressure area - by a moderate effective exhaust speed, e.g. 1.5 or more times conventional levels, specifically 800 l/sec or more effective exhaust speed; (2) to increase the etch speed a moderate effective exhaust speed e.g. 1.5 or more times conventional levels, and to increase the anisotropy to a moderate 1.5 or more times over conventional levels, typically requiring 5 mTorr or less gas pressure; and (3) to double or more the etch speed of conventional levels, and to increase the anisotropy to double or more of that of conventional levels, i.e. requiring 1300 l/sec or more effective exhaust speed, and 1 mTorr or less gas pressure.

From the standpoint of improving the process, method (3) is optimal. However since there are various processing procedures in semiconductor manufacture and equipment cost to be taken into consideration, application of methods (1) and (2) are feasible for obtaining the required quality at low cost.

In the above mentioned equation (1) the relationship among gas pressure P, exhaust speed S, and gas flow rate Q is expressed as P=Q/S. So, in order to satisfy the requirements of the invention, the required gas flow rate may be 32 sccm, when the required minimum gas pressure is 0.5 mTorr, and the effective exhaust speed is 800 l/sec. However, 40 sccm or more is preferable, taking fluctuations into account, since in reality gas pressure is finely regulated.

Here, since the discharge becomes unstable at 0.01 mTorr or less gas pressure, it is preferable that the lower limit of the gas pressure exceeds 0.01 mTorr.

Also, the exhaust speed, even at maximum, should not exceed 100,000 l/sec effective exhaust speed, taking the size of the apparatus into consideration.

Gas residence time should be 0.1 msec or more, taking into account the capacity of the vacuum treatment chamber, the upper limit of the above-mentioned exhaust speed, and the reaction time at the etching surface.

Also the gas flow rate should not exceed 10,000 sccm, taking gas usage cost and flow regulation into consideration.

Particular features of the invention as claimed are:-

increasing the effective cross-sectional area of the gas inlet to lower the incoming gas flow speed to below one third of the speed of sound;
providing a buffer zone in the form of mesh-like small holes at the gas inlet;
arranging the gas outlet close to the sample stage, and the gas inlet position in the vacuum chamber away from the sample stage, and directing the gas inlet toward the center of the vacuum chamber or of the discharge zone;
mounting a plurality of gas piping and gas inlets around the vacuum chamber of discharge zone preferably in a symmetrical arrangement, the gas piping and gas inlets being used to pass the gas whose flow rate is controlled by the gas flow rate controller;
providing a shielding in the vacuum chamber that controls the flow of the gas;
setting the height-width ratio of the discharge zone at more than 0.5;
locating the gas inlet within the upper third of the height of the discharge zone;
providing an exhaust buffer zone between the exhaust system and the discharge zone;
setting the pump evacuation speed typically to more than 2,500 l/s, preferably more than 4,000 l/s, and the exhaust conductance preferably to more than 3,000 l/s, to achieve the preferred effective exhaust speed of higher than 1,300 l/s.

The term "conductance" used herein is known to experts in this field. It can be defined as the amount of gas that flow through a component of a vacuum system, divided by the pressure difference across the component. It is more generically a measure of the ease of flow of gas through a vacuum system, thus being analagous to electrical conductance. In the present case, the term conductance refers, where appropriate to the conductance of the treatment chamber as a whole, including the conductance valve or valves.

Preferably the residence time of the reaction gas in the vacuum chamber is less than 100 ms. By using a large vessel, batch processing on a plurality of samples, e.g. large-diameter wafers, simultaneously is possible.

In one particular embodiment of the invention as claimed, the following features are combined: providing a gas outlet at the center of the sample stage in a large vessel; increasing the gas flow introduced into the large vessel beyond 10 sccm; setting the area of an electrode that forms the sample stage to more than 5,000 $cm^2$; setting the overall exhaust conductance of the vacuum chamber to more than 3300 1; using a vacuum pump with the pumping speed of more than 5,000 l/s; and setting the effective gas exhaust rate to more than 2,000 l/s.

The invention as claimed is believed to be effective for the following reasons.

With the conventional dry etching machines, lowering the gas pressure results in a significant reduction in the etching rate, making it impossible to obtain a useful etching rate. This is considered to be because the lower gas pressure reduces the amount of reaction gas in the vacuum chamber. The present inventors have made a number of studies to gain a high etching speed or etch rate while lowering the gas pressure. It was found that when the reaction gas first strikes the sample to be etched, the etching takes place. In other words, if a greater amount of unreacted reactive gas is present in the reaction chamber than reacted gas (reaction product), it was found that the etching speed or etch rate can be increased even at the same gas pressure. Then, a further study was conducted on factors that determine the ratio between the unreacted reactive gas and the reaction product.

Figure 5 shows the calculated result of the ratio of a gas incident on a substrate to the sum of reactive gas and total incident particles (reactive gas + reaction product) when the gas flow rate varies. The incident gas ratio is given by

$$R = 1/(1 + 2.735x10^2 C_1 \cdot A \cdot P/(\alpha \cdot Q)) \qquad (4)$$

where $C_1$ is a constant determined by the etched material and the etching gas and has a range of between 0.1 and 10; A is an area to be etched; P is a gas pressure; $\alpha$ is a gas utilization factor, a constant ranging from 10 to 100% that is determined by the discharge efficiency of the introduced gas in the etching machine and the shapes of the vacuum chamber and discharge zone; and Q is a gas flow rate. Figure 5 shows the result of calculation assuming the etching area A to be 78.5 $cm^2$, gas utilization factor $\alpha$ to be 42%, and gas pressure to be 0.5 mTorr. The figure shows that the ratio of the reactive gas increases with the gas flow rate. Figure 6 shows the result of calculating variation in the residence time of the gas in the vacuum chamber by using the expression (3) when the gas flow rate is varied with the gas pressure kept constant. As the gas flow rate increases, the gas residence time sharply reduces. Therefore, as the gas flow rate increases, the residence time of the reaction product in the vacuum chamber reduces causing the reaction products to be exhausted swiftly from the vacuum chamber, promoting the etching reaction and increasing the etch rate. However, when the gas flow rate is increased without changing the equipment configuration, since the effective gas exhaust rate is constant, the gas pressure increases as shown in Figure 17, decreasing the anisotropy. Figure 17 shows that the greater the effective gas exhaust rate, the higher the gas flow rate at the gas inlet under the same gas pressure. In other words, by increasing the effective gas exhaust rate, it is possible to increase the gas flow rate at the same gas pressure.

Figure 7 shows the result of calculation as to the relationship between the ratio of reactive gas to total incident particles and the gas residence time in the vacuum chamber, by using equation (3) and equation (4). The calculation assumes that the total volume of the vacuum chamber is 100 1, the etching area A 78.5 $cm^2$, and gas utilization factor $\alpha$ 42%. Figure 7 indicates that as the gas residence time decreases, the ratio of reactive gas increases, showing a significant change during the region between 1 sec to 100 msec. It follows therefore that to perform the etching reaction efficiently requires for example the gas flow rate to be set higher than 40 sccm or preferably higher than 100 sccm from Figures 5 and the gas residence time to be set lower than 100 msec or preferably lower than 50 msec from Figure 7 when the ratio of the reactive gas to the total wafer incident particles is taken to be more than 60%.

When the volume of the vacuum chamber is less than 100 1, the desired gas residence time can be achieved by setting the flow rate of gas flowing in the chamber at more than 1300 l/s. Setting the effective opening area of the gas inlet to 150 $cm^2$ by means of mesh-like small holes formed in the buffer zone reduced the gas flow speed at the gas inlet to less than one third of the speed of sound, preventing the gas from forming into a high-speed flow. This in turn suppressed the shock waves accompanying the gas flow, thereby reducing the instability and non-uniformity of plasma.

When the gas inlet is installed remote from the side portion of the sample stage, which forms a gas outlet for the discharge zone, the gas flow is able to disperse sufficiently in the discharge zone, efficiently transforming the gas into plasma and therefore increasing the etch rate and uniformity. Further, since the gas inlet is directed toward the center of the vacuum chamber or discharge zone, which in turn has resulted in improved speed and uniformity of etching.

Arranging the gas piping through which the gas flow passes under control by the gas flow rate controller, around the vacuum chamber or discharge zone in good symmetry has made it possible to prevent the deviation of gas flow in the vacuum chamber or discharge zone. This improves the uniformity of etching. Installation of the gas inlets also has taken the symmetry into account, so that the gas flow uniformity also improved.

Provision of shielding has enabled control of the gas flow in the vacuum chamber. In particular, this made it possible to form a gas flow where plasma is generated, increasing the etch rate.

By setting the height-width ratio of the discharge zone to more than 0.5, a sufficient amount of gas passes to the center of the discharge zone. This is explained by referring to Figure 15. The figure shows the result of simulating the effects that the height-width ratio of the discharge zone has on the gas flow density in the discharge zone. The diagram shows that increasing the height-width ratio of the discharge zone increases the gas flow density above the wafer located at the center of the discharge zone, improving the gas flow uniformity. In this way, the invention has enabled the gas to flow efficiently and uniformly through the center of the discharge zone, thereby increasing the plasma density and uniformity. As a result, it has become possible to perform etching at high speed and good uniformity.

In dry etching machines, the lower the gas pressure, the smaller the frequency that the ions coming from plasma and impinging on the wafer are scattered and the higher the etching anisotropy. With this invention, it is possible to perform the low-pressure anisotropic etching with good uniformity at a practical etch rate.

Using a large vessel in the process of dry etching, a large number of samples can be processed at one time, improving throughput. When a large vessel is used, it is particularly important to exhaust the reaction products generated as a result of etching reaction out of the vessel. This requires a high-speed evacuation. The conventional machines commonly have a turbo-molecular pump with the pumping speed $S_0$ of about 1,000 l/s or less. For an exhaust conductance C of 200 l/s to 1,000 l/s, the evacuation speed is 100 to 400 l/s. Hence, when the gas pressure is set at 5 mTorr, the gas flow rate that can be achieved is 40 to 200 sccm. Because of the above-mentioned high-speed vacuum pump and large exhaust conductance, this invention can with large chambers achieve the gas flow rate of 800 sccm at 5 mTorr by setting the effective evacuation speed to 2,000 l/s or more.

Figure 18 shows the relationship between effective speed of exhaust and the gas residence time when the vacuum chamber volume is changed from 100 to 10,000 1. The gas residence time can be made shorter than 100 msec by setting the effective exhaust speed to more than 700 l/s for the vacuum chamber volume of 100 1, to more than 3,600 l/s for the vacuum chamber volume of 500 1, and to more than 70,000 l/s for the vacuum chamber volume of 10,000 1. For example, to achieve the effective exhaust speed of 70,000 l/s requires, from equation (2), the use of a vacuum pump with the pumping speed of 140,000 l/s and a vacuum chamber with an exhaust conductance of 140,000 l/s.

By providing a gas outlet at the center of the sample stage, the density of process gas at the center and around the sample stage can be made uniform.

Embodiments of the invention as claimed as well as examples not being embodiments will now be described by way of non-limitative example with reference to the accompanying drawings, in which:-

Fig. 1 is a simplified cross section of a microwave plasma etching machine of a high-vacuum , high-speed exhaust type which can be used in this invention.

Fig. 2 is a graph showing the relationship between the gas flow rate and the etch rate in the process of Si etching using a microwave plasma etching machine.

Fig. 3 is a graph showing the relationship between the gas pressure and the undercut width in the process of Si etching using a microwave plasma etching machine.

Fig. 4 is a graph showing the relationship between the gas pressure and the etch rate in the process of Si etching using a microwave plasma etching machine.

Fig. 5 is a graph showing the result of calculation as to the ratio of the reactive gas to the total incident gas including reaction products striking the substrate when the gas flow rate is varied.

Fig. 6 is a graph showing the result of calculation of the residence time of the gas in the vacuum chamber when the gas flow rate is varied.

Fig. 7 is a graph showing the result of calculation of the ratio of the reactive gas to the total incident gas including reaction products striking the substrate when the gas residence time is varied.

Fig. 8 is a simplified cross section of a high-vacuum, high-speed exhaust type reactive ion etching machine which can be used in this invention.

Fig. 9 is a simplified cross section of a dry etching machine which can be used in this invention.

Fig. 10 is a partial plan view of a further dry etching machine which can be used in this invention.

Fig. 11 is a partial plan view of another dry etching machine which can be used in this invention.

Fig. 12 is a partial plan view showing the gas piping arrangement of a dry etching machine which can be used in this invention.

Fig. 13 is a partial plan view showing the gas piping arrangement of another dry etching machine which can be used in this invention.

Fig. 14 is a simplified cross section of yet another dry etching machine which can be used in this invention.

Fig. 15 is a graph showing the result of simulation of the relationship between the ratio of height to width of the discharge zone and the density of gas flow in the discharge zone.

Fig. 16 is a simplified cross section of a conventional dry etching machine, as discussed above.

Fig. 17 is a graph showing the relationship between the gas pressure and the gas flow rate at different effective exhaust speeds.

Fig. 18 is a graph showing the relationship between the effective exhaust speed and the gas residence time with the vacuum chamber volume taken as a parameter.

Figs. 19a and 19b are simplified perspective and side views of a large-vessel, high-speed exhaust reactive ion etching machine which can be used in this invention.

Fig. 20 is a graph showing the relationship between the gas flow rate and the etching speed during the process of Si etching using a large-vessel, high-speed exhaust reactive ion etching machine.

Fig. 21 is a simplified view of another large-vessel, high-speed exhaust microwave plasma etching machine which can be used in this invention.

Fig. 22 is a graph of Al etch speed and effective exhaust speed in Example 6.

Fig. 23 is a graph of Si etch speed and wafer ECR surface distance in Example 7.

Fig. 24 is a graph of reaction products on wafer surface and wafer ECR surface distance in Example 7.

Fig. 25 is a graph of Al etch speed and effective exhaust speed in Example 8.

Fig. 26 is a graph of Al undercut amount and effective exhaust speed in Example 8.

Fig. 27 is a graph of Al undercut amount and gas pressure in Example 9.

Fig. 28 is a graph of Al etching depth ratio (pattern size dependency) and effective exhaust speed in Example 9.

Fig. 29 is a diagrammatic view of a high speed exhaust reactive ion etching (RIE) device which can be used in this invention;

Fig. 30 is a graph of Al etch speed and gas pressure in Example 10.

Fig. 31 is a graph of Al etch speed and effective exhaust speed in Example 10.

Fig. 32 is a graph of Al etch speed and gas residence time in Example 11.

Fig. 33 indicates exemplary ranges of effective exhaust speed and treated gas pressure to which this invention applies.

In the different figures, the same reference numbers are used for corresponding parts.

One example of a high-speed exhaust microwave plasma etching machine which can be used in this invention is shown in Fig. 1. An etching gas is introduced into a vacuum chamber 1, a microwave source 2 generates a high frequency of 2.45 GHz, and the generated frequency is sent through a waveguide 3 to a discharge zone 4 where it produces gas plasma 5. For effective discharge, a field generation solenoid coil 6 is arranged around the discharge zone so that the magnetic field of 875 gauss generates high-density plasma by electron cyclotron resonance (ECR). There is a sample stage 7 in the discharge zone, and a wafer 8 put on this sample stage 7 is etched by the gas plasma. The etching gas is introduced from a gas inlet 9 into a buffer zone 15 and a discharge zone 4 and then exhausted through an exhaust buffer zone 10 out of a vacuum chamber 1 by vacuum pumps 11 via conductance valves 12. By making the conductance valves 12 variable, it is possible to change the exhaust or evacuation speed. The etching gas is supplied through a gas flow rate controller 13 and gas piping 14 and introduced into the discharge zone 4 from the gas inlet 9 through the buffer zone 15 made up of small mesh-like holes. The gas inlets 9 are provided at two or more locations and arranged symmetrically with respect to the center axis of the discharge zone 4. The sample stage 7 for the wafer is provided with a cooling mechanism 16 that cools the wafer below 0°C and which can be applied with an RF bias 17 of 13.56 MHz to 400 kHz. The vacuum chamber 1 is provided with a heater 18 to heat it above 50°C. A sensor 23 measures gas pressure at the discharge zone.

The vacuum pumps 11 are two turbo-molecular pumps with a pumping speed of 2,000 l/s to give a total exhaust speed of 4,000 l/s, and are arranged symmetrically with respect to the center axis of the discharge zone. Zone 10, which is essentially a gas exhaust outlet in the vacuum treatment chamber, is also arranged symmetrically to the central axis of the wafer. This enables the gas flow to be symmetrical to the center of the wafer, while greatly increasing the exhaust conductance. The total exhaust conductance of the vacuum chamber 1 is set to 4,000 l/s. Because of this, the diameter of the bottom of discharge zone 4, is made larger than that of the top, which results in making the diameter of magnetic field coil 6 installed in this area larger than the diameter of the coil 6 positioned above. The wafer was designed to be, at the time of etching, positioned lower than the center of the coil axis in the direction of the thickness of the coil i.e. vertically, in Fig. 1, at its lowest level, with an extremely large exhaust conductance below the discharging area. The maximum resulting effective exhaust speed is 2,000 l/s. The volume of the vacuum chamber 1 is 100 l and the residence time of the gas in the vacuum chamber 1 is 50 msec, calculated from equation (3).

Example 1

Using this high-speed evacuation microwave plasma etching machine, etching was performed on a crystalline Si to form grooves. The sample is a Si substrate formed with a thermal oxidized film 500 nm thick, which is further covered with a photoresist mask to dry-etch the oxidized film to form a hole pattern 0.1µm to 1.0µm in diameter. After this, the photoresist mask is removed, leaving a $SiO_2$ mask. $Cl_2$ gas is used as the etching gas. The gas pressure is set to 0.5 mTorr, the microwave power to 500 W, the RF bias to 20W at 2 MHz, and the wafer temperature to -30°C. The gas flow was changed between 2 sccm and 100 sccm. The magnetic field intensity distribution is set so that it decreases from the top of the discharge zone downwardly and so that the 875 gauss field that provides the ECR condition is located 40 mm above the wafer.

The dependence of the Si etch rate on the gas flow rate is shown in Fig. 2. The etch rate increases with the $Cl_2$ gas flow rate, from 80 nm/min at 2 sccm to 1,300 nm/min at 100 sccm. In this experiment, 30 sccm is equivalent to 800 l/s exhaust speed. Fig. 3 shows the relationship between the gas pressure and the width of undercut of the Si from the mask. The etched shape of Si substrate has high directivity because of low gas pressure of 0.5 mTorr and the undercut width of a Si hole 5 μm deep was less than 0.03 μm, exhibiting almost no gas flow rate dependence.

Fig. 4 shows the dependency of Si etching speed on the gas pressure in a machine with effective exhaust speed of 2,500 l/s and in a conventional machine with the effective exhaust speed of 150 l/s. The etching conditions are the same as those of Fig. 2. With the conventional etching machine, the Si etch rate sharply decreases with the gas pressure. This is because the gas residence time is as long as 470 ms and the exhaust speed is slow, resulting in a reduced gas flow rate at low gas pressure. The etching machine of this invention with high evacuation speed, however, provides a high etch rate more than 10 times that of the conventional equipment at a low gas pressure of less than 0.5 mTorr. For the gas pressure of 0.5 mTorr or lower, the etching was able to be carried out at high speed of more than 1 μm/min. At the same time, there is little dependency of the etching speed on the hole diameter, with the etching speed variation falling within 3% for the hole diameters ranging from 0.1 μm to 1.0 μm. The $SiO_2$ etch rate shows little change even when the gas flow rate is changed. At the gas flow rate of 100 sccm, the selectivity between Si and the etching mask $SiO_2$ was approximately 50.

The etching of a phosphorus-doped polysilicon produced similar results to Figs. 2 and 3. At the $Cl_2$ flow rate of 100 sccm, the etch rate was 1500 nm/min and the undercut width less than 0.03 μm.

Example 2

Using the high-speed exhaust microwave plasma etching machine shown in Fig. 1, $SiO_2$ used for a contact hole was etched. The sample consists of a Si substrate which is formed with a Si oxidized film 2 μm thick by the chemical vapor deposition method and then formed with a photoresist mask thereover. The etching gas is $CHF_3$, and the gas pressure is set to 0.5 mTorr, microwave power to 500W, RF bias to 200W at 800 kHz and wafer temperature to 30°C. The gas flow rate is varied from 2 to 100 sccm. The etch rate increased with the $CHF_3$ gas flow rate, from 50 nm/min at 2 sccm to 500 nm/min at 100 sccm. As in Example 1, 30 sccm is equivalent to exhaust speed of 800 l/s. The etched shape of the $SiO_2$ has high directivity because of the low gas pressure of 0.5 mTorr, with the undercut width being less than 0.05 μm for $SiO_2$ holes 2 μm deep, demonstrating little or no dependence on the gas flow rate. Further, the dependence of the etching speed on the hole diameter is small, with the speed variation falling within 3% for the hole diameters of 0.1 μm to 1.0 μm. The selection ratio between the $SiO_2$ and the photoresist increased more than twice when the gas flow rate was increased from 2 sccm to 100 sccm.

Fig. 8 shows another high-speed exhaust reactive ion etching machine. Since this is a magnetron-type RIE system having a magnetic field coil, discharge is possible even at 1 mTorr or less. The etching gas is introduced into a vacuum chamber 1 and a discharge is produced at a high frequency of 13.56 MHz to generate gas plasma 5. In a discharge zone 4 there is a sample stage 7 on which a wafer 8 is mounted and etched by gas plasma. The etching gas is introduced from gas inlets 9 into a buffer zone 15, then to discharge zone 4 and then into an exhaust buffer zone 10 and then exhausted by vacuum pumps 11 out of the vacuum chamber 1. By making conductance valves 12 variable, it is possible to change the exhaust or evacuation speed. The etching gas is supplied through gas flow rate controllers 13 and gas piping 14 and introduced into the vacuum chamber 1 from the gas inlet 9 through the buffer zone 15 which has an outlet made up of small mesh-like holes. The gas inlets 9 are provided at two or more locations and arranged symmetrically with respect to the center axis of the discharge zone 4. The sample stage 7 for the wafer 8 is provided with a cooling mechanism 16 that cools the wafer below 0°C. The vacuum chamber 1 is provided with a heater 18 to heat it above 50°C.

The vacuum pumps 11 are two turbo-molecular pumps with the evacuation speed of 2,000 l/s, which are arranged symmetrically with respect to the center axis of the discharge zone. The total exhaust conductance of the vacuum chamber 1 is set to 4,000 l/s. The resulting effective exhaust speed is 2,000 l/s. The volume of the vacuum chamber 1 is 100 l and the residence time of the gas in the vacuum chamber 1 is 50 ms, as calculated from equation (3).

Example 3

Using a high-speed evacuation reactive ion etching machine as shown in Fig. 8, etching was performed on a photoresist used for a multilayer resist mask. The sample consists of a Si substrate with a photoresist applied to the thickness of 1.5 μm and baked to form an intermediate layer of spin-on-glass (SOG) or titanium silica. This intermediate layer is then patterned by a photoresist and then dry-etched to form a mask, which will be used for etching a sublayer photoresist. Oxygen is used as the etching gas, and the gas pressure is set to 0.5 mTorr, RF power to 500 W and wafer temperature to -100°C. The gas flow rate is varied from 2 sccm to 100 sccm. Again, 30 sccm is equivalent to an exhaust speed of 800 l/s. The etch rate increased with the $O_2$ gas flow rate, from 100 nm/min at 2 sccm to 1,000 nm/min at 100 sccm. The etched shape of the resist has high directivity because of low gas pressure of 0.5 mTorr, with the undercut width for the resist 1.5 μm deep being as small as 0.05 μm or less, exhibiting little gas flow rate dependence.

Furthermore, the dependence of the etching speed on the hole diameter is small, with the speed variation falling within 3% for the hole diameter range from 0.1 μm to 1.0 μm.

Another machine which can be used in this invention is shown in Fig. 9. Microwaves generated by a microwave source 101 are introduced through a waveguide 102 and a microwave inlet 103 into a discharge zone 117 in a vacuum chamber 111. The gas is regulated in its flow rate by gas flow rate controllers 106 and supplied through gas piping 105 to the vacuum chamber 111. Having passed through the gas inlet 104, which is located at the end of the gas piping 105, the gas enters through a buffer zone 116, which has mesh-like small exit holes, into the vacuum chamber 111.

The gas, which has entered into the discharge zone 117, is controlled in its flow by a shielding 108 so that the density in the central portion of the discharge zone 117 is uniform. The gas flow above a wafer 109 is excited by the microwaves to be transformed into plasma, which generates active particles that in turn etch the wafer 109. Solenoid coils 107 are adjusted so as to apply an external magnetic field to the plasma thereby enabling the microwave energy to be transmitted to the plasma.

A sample stage 110 can be subjected to an RF bias by an RF power supply 112. The RF power supply 12 applies a bias voltage to the wafer 109 to control the direction and energy of the incident ions. A cooling and heating mechanism may be provided to the sample stage 110 to control the wafer temperature during the etching.

Having entered from the gas inlet 104 into the vacuum chamber 111, the gas flow is transformed into plasma in the discharge zone 117 where it is used for etching the wafer 109. The gas flow, together with reaction products, is then carried past the side of the sample stage 110, which doubles as a gas outlet for the discharge zone 117, and is exhausted through an exhaust buffer zone 113 by a vacuum pump 114.

When a high-speed vacuum pump is used or when a plurality of vacuum pumps are used, the exhaust buffer zone 113 contributes to making uniform the evacuation speed of the gas flowing past the side of the sample stage, which represents a gas outlet when viewed from the discharge zone 117. As a result, a uniform etching can be carried out.

Components in this machine that control the gas flow include the buffer zone 116, the shielding 108 and the exhaust buffer zone 113.

In the conventional machines, no special arrangement is provided at the gas inlet 104. The gas piping 105 is directly connected to the vacuum chamber 111 and no special consideration is made as to their connection position. One example of the conventional machine is shown in Fig. 16. The gas piping 105 is directly fitted to the vacuum chamber 111.

The machine used in this invention as claimed is preferably characterized in that by increasing the effective area of the opening at the gas inlet, the gas flow speed does not exceed one third the speed of sound. In the machine shown in Fig. 9, the buffer zone 116 is provided at the gas inlet 104A and formed with mesh-like small holes in its wall surface to increase the effective opening area at the gas inlet and thereby keep the gas flow speed below one third the speed of sound.

The pressure of gas flowing through the gas flow rate controllers 106 and the gap piping 105 is about 1 atmosphere. When the gas is supplied directly into the vacuum chamber 111, the pressure difference between the gas flow and the vacuum chamber is likely to cause a disturbance in the flow where the gas enters the vacuum chamber 111. With this machine, the provision of the buffer zone 116 between the gas inlet 104 and the vacuum chamber 111 suppresses the flow turbulence that would otherwise occur due to pressure difference.

This machine has piping 105, including the gas flow rate controllers 106, arranged symmetrically around the vacuum chamber 111 to further enhance the uniformity of gas flow.

As the plasma is formed closer to the central area of the discharge zone, the active particles strike the wafer more efficiently enhancing the etching uniformity. Gas flow along the wall surface of the discharge zone 117 contributes little to the etching. To make the gas flow run close to the central area of the discharge zone 117, this embodiment employs the shielding 108. Since the shielding 108 also has a bad effect of deteriorating the conductance of the flow, too large a shielding may produce an adverse effect. In this embodiment, the size of the shielding 108 is determined such that the gap between the sample stage 110--which works as a gas outlet for the discharge zone 117--and the vacuum chamber 111 is not seen from the mesh of the buffer zone 116 and that the shielding does not overlap the wafer 109.

This machine is also characterized by the exhaust buffer zone 113 provided at the exhaust pump 114 for the control of the gas flow. For a uniform flow, the exhaust system is preferably arranged symmetrically. However, since the sample stage 110 needs to be connected to the RF power supply 112 for bias application or provided with a cooling mechanism that circulates coolant to control the wafer temperature for low-temperature dry etching, it is difficult to arrange the exhaust system including the vacuum pump in good symmetry. The exhaust buffer zone 113 provided in this machine serves to distribute the exhaust capacity of the vacuum pump 114 uniformly over the exhaust portion of the discharge zone 117. When a plurality of vacuum pumps are used to increase the exhaust capacity, the exhaust buffer zone 113 has a good effect of making the gas being exhausted from the discharge zone 117 distributed uniformly.

Fig. 10 shows a horizontal cross section of the vacuum chamber 111 including the gas piping 105. While there are shown four inlet pipes, a single pipe may be used because the buffer zone 116 is provided. However, for uniform flow, two or more such pipes are preferably installed in a symmetrical arrangement.

Example 4

Using the microwave dry etching machine with the above construction, an Si substrate surface was etched to form holes and grooves 0.3-3.0 μm in size. The sample is patterned with a resist mask or $SiO_2$ mask. $SF_6$ gas is used as an etching gas, and the microwave power to set to 400 W, the gas pressure to 0.5 mTorr, the gas flow rate to 50 sccm, and the RF bias to 30 W (13.56 MHz). The exhaust speed is 1333 l/s. The etching speed obtained was higher than 500 nm/min. The side etch width was less than 0.05 μm, providing a good vertical shape.

Fig. 11 shows another machine which can be used in this invention. This machine employs independent buffer zones 116, corresponding in number to the inlet gas pipes, rather than the circular buffer zone 116 of Fig. 10. Comparison has found that the machine of Fig. 9 has better uniformity of gas flow, but the machine of Fig. 11 has the advantage of being able to be manufactured easily.

The shielding 108 can be formed as separate and multiple shielding, rather than a circular one. It is also possible to install a plurality of circular shieldings 108 in the vacuum chamber 111 at locations different in height from each other, or to use a combination of circular shielding and separate shielding, or to arrange shielding of different sizes and shapes at various locations in the vacuum chamber 111 to control the gas flow. In this way, the provision of the buffer zone 116 has improved the etching speed uniformity in a 20 cm (8 inch) wafer by more than two times when compared with the equipment without a buffer zone, thus limiting the etch rate variations to within ±10%.

Fig. 12 shows another way of arranging the gas piping. In this machine, the gas piping 105 is connected to the vacuum chamber 111 at multiple locations, whereas the gas flow supplied from the gas cylinder 115 is controlled by only one gas flow rate controller 106. Since the gas flow is controlled by a single gas flow rate controller, this machine has the advantage of making it possible to control the gas flow accurately and of having a simple construction. There is, however, a disadvantage that since the length of the gas piping 105 from the gas flow rate controller 106 to the vacuum chamber 111 varies from one connection to another, the uniformity of the gas flow in the discharge zone 117 deteriorates to some extent. This reduction in the gas flow uniformity poses no serious problem because the gas flow uniformity can be adjusted by making changes in the system, such as changing the sizes of the buffer zones 116 according to locations, or changing the opening area and opening degree of the mesh-like holes or adjusting the mounting height of the buffer zone according to the location. The use of such gas piping 105 has improved the etching speed uniformity of the 8-inch wafer by a factor of more than two when compared with the equipment having a single gas piping, thus limiting the etch rate variations to within ±10%.

Fig. 13 shows still another arrangement of gas piping. In this example, multiple inlet gas pipes connected to the vacuum chamber 111 are each provided with one or more gas flow rate controllers 106 to control the gas flow supplied from one or more gas cylinders 115. By regulating the gas flow through the gas flow rate controller 106, the gas flow in the vacuum chamber 111 can be made uniform. Besides the method of using two or more gas cylinders containing the same kind of gas for making the gas flow in the vacuum chamber uniform, another method is available that uses cylinders containing different kinds of gases so that they can be mixed in the vacuum chamber. By adjusting the number and positions of the gas piping for each kind of gas and by regulating the gas flow running through these pipes, it is possible to thoroughly mix different kinds of gases and make uniform the flow of gas mixture in the vacuum chamber. In this way, the use of a plurality of inlet gas pipes and gas cylinders 115 has improved the etching speed uniformity for a 20 cm (8 inch) wafer by a factor of more than two when compared with the equipment using a single gas cylinder, thus limiting the etch rate variations to within ±10%.

A further machine which can be used in this invention as claimed is shown in Fig. 14. This machine has a buffer zone 116 below the microwave inlet 103 and a multi-aperture gas inlet 104 above the wafer 109. This arrangement has the advantage of improving the uniformity of gas flow, particularly increasing the gas flow density at the center of the discharge zone 117. This construction, however, has the disadvantage that a high gas pressure that occurs in the path of the microwave may hinder the propagation of the microwave or may cause discharges in the buffer zone 116. In practice, however, this does not pose a grave problem since it can be avoided by making adjustments of the microwave power and solenoid coil 107 or by time-modulating the gas flow to suppress a pressure increase in the buffer zone 116 and emitting the microwave in synchronism with the time modulation.

A large-vessel high-speed evacuation reactive ion etching (RIE) machine which can be used in this invention as claimed is shown in Figs. 19a and 19b. The etching gas is introduced into a vacuum vessel 201 and discharges are produced by an RF power supply 202 to generate gas plasma 203. The vessel 20 is cylindrical in shape, 120 cm in diameter and about 40 cm high. It has a parallel-plate cathode coupling electrode, with the upper electrode 204 at an earth potential and the lower electrode 205 used to apply high frequency. The lower electrode 205 also serves as a sample stage on which to mount wafers. The lower electrode, 90 cm in diameter, has a gas outlet 206 10 cm in diameter at its center to exhaust the etching gas so that the gas can be evacuated from the center of and from around the lower electrode to improve the etching uniformity. The electrode area is about 6,300 $cm^2$ and six 20 cm (8 inch) wafers 207 are placed on the electrode for simultaneous etching. The evacuation speed of the etching gas can be changed by adjusting the conductance valves 208. The etching gas is passed through gas controllers 209 and gas piping 210 and introduced from gas inlets 211 into a vessel 201 through a buffer zone 212 which has mesh-like small outlet holes. There are two or more gas inlets 211 arranged symmetrically with respect to the center axis of the discharge zone. The sample stage on which the wafer is placed has a cooling mechanism 213 to cool the wafers below 0°C. A heater 214 is provided to the vessel 201 to heat it to 50°C or higher.

The vacuum pumps 215 are two turbo-molecular pumps with pumping speed of 6,000 l/s, arranged symmetrical with respect to the center axis of the discharge zone. The exhaust conductance of the vessel 201 is 12,000 l/s. The effective speed of exhaust is 6,000 l/s. The vessel 201 has a volume of about 500 l and the residence time of the gas in the vessel 201 is 83 ms, as determined from the equation (3).

A large-vessel high-speed evacuation microwave plasma etching machine which can be used in this invention as claimed is shown in Figs. 21a and 21b. The vessel 201 has five discharge zones 216, each of which can independently generate a gas plasma 203. Five 20 cm (8 inch) wafers 207 are put on the sample stage in the vessel below the corresponding five discharge zones and subjected to simultaneous etching. In the sample stage, gas outlets 206 are formed in the vicinity of the five wafer mounting positions. The etching gas is introduced into the vessel 201 and a high frequency of 2.45 GHz generated by microwave sources 217 is supplied through waveguides 218 into discharge zones 216 where it transforms the gas into gas plasma. For efficient discharge, magnetic field generating solenoid coils 219 are installed around the discharge zone so that a magnetic field of 875 gauss produces highly dense plasma by electron cyclotron resonance. The etching gas is introduced from gas inlets 211 into the discharge zones 216 and then exhausted out of the vessel 201 by vacuum pumps 215. The exhaust speed can be changed by varying conductance valves 208. The etching gas is passed through gas flow rate controllers 209 and gas piping 210 and introduced from the gas inlets 211 into the discharge zones 216 through buffer zones 212 which have mesh-like small outlet holes. Two or more gas inlets 211 are arranged symmetrically with respect to the center axis of each discharge zone. The sample stage on which the wafers are mounted is provided with a cooling mechanism 213 that cools the wafers below 0°C and to which can be applied an RF bias 202 of 13.56 MHz to 400 kHz. The vessel 201 has a heater 214 to heat it to 50°C or higher.

The vacuum pumps 215 are two turbo-molecular pumps with the pumping speed of 20,000 l/s arranged symmetrical about the center of the vessel 201. The exhaust conductance of the vessel 201 is set to 40,000 l/s. The effective speed of exhaust is 20,000 l/s. The total volume of the vessel 201 and discharge zones 216 is approximately 2,000 l and the residence time of the gas in the vessel 201 is 100 ms.

Example 5

With this large-vessel, high-speed exhaust microwave plasma etching machine of Figs. 21a and 21b, Si monocrystalline substrates were etched. Each sample is a 20 cm (8 inch) Si substrate formed with a photoresist mask. Five of them are placed on the same sample stage. $CF_4$ is used as an etching gas, and the gas pressure is set to 5 mTorr, the microwave power to 2 kW, the RF bias to 200 W at 2 MHz, and the wafer temperature to -50°C. The Si etch rate under this condition was 1.5 μm/min at the gas flow rate of 900 sccm. The undercut width of Si from the mask when the substrate was etched 1 pm deep was less than 0.1 μm. The selectivity between Si and photoresist was 3.0. The etch rate uniformity within each wafer and among different wafers was less than ±5%.

Example 6

Using the high speed exhaust microwave plasma etching device shown in Fig. 1, patterns which varied in total area were formed on an 8 inch wafer, and Al etching was performed. Etching conditions were: 3 mTorr $Cl_2$ gas pressure, 500 W microwave power, 50 W RF bias at 2 MHz and 0°C wafer temperature. Fig. 22 shows the relationship between the effective exhaust speed (hereafter referred to simply as exhaust speed in the explanation of experiments) and the etch speed, when the wafer diameter is changed from 6 inches to 8 inches. The ratio of the etching area in the wafer was 50%. Since the gas pressure was constant (3 mTorr), the gas flow rate (Q sccm) relation to exhaust speed (S l/s) was : Q = 79.05 x S x 0.003.

Previously for Al etching at a low exhaust speed (approx. 200 l/s) for 6 inch wafers, the etch speed was about 0.8 μm/min. When the exhaust speed was 500 l/s, the etch speed became 1.2 μm/min, i.e. about 1.5 times faster; when it was 800 l/s, the etch speed was 1.4 μm/min, i.e. about 1.8 times faster; and when it was 1300 l/s, the etch speed was 1.6 μm/min, i.e. double. For an 8 inch wafer, even more marked changes were recognized: at 800 l/s, etch speed 2.4 times faster than usual; and at 1300 l/sec, about triple the usual etch speed.

Accordingly, it was discovered that if the object is to obtain for an 8 inch wafer an etch speed 1.5 times or more that of the conventional etch speed (6 inch, 200 l/s), an exhaust speed of at least 800 l/s or more is needed; and that if the target is to obtain more than double this conventional speed, an exhaust speed of at least 1300 l/s or more is needed.

Incidentally this etch speed dependency on area has been found to be somewhat similar in materials other than Al, such as Si, etc. In order to obtain 1.5 times or more the conventional etch speed for an 8 inch wafer, 800 l/s or more exhaust speed was needed. Also, when etching conditions varied, such as gas pressure, microwave power, sample temperatures, bias, etc. 800 l/s or more exhaust speed was needed to obtain 1.5 times or more the conventional etch speed for an 8 inch wafer.

Example 7

Using the high speed exhaust microwave plasma etching device shown in Fig. 1, the distance (the ECR surface distance) between the ECR surface (surface when the magnetic field becomes 875 G in plasma) and the wafer was changed, and Si etching was performed. Etching conditions were: 0.5 mTorr $Cl_2$ gas pressure, 500 W microwave power, 20 W RF bias at 2 MHz, and -30°C wafer temperature. Fig. 23 shows the relationship between the ECR surface distance and etch speed when the exhaust speed is changed. At a conventional exhaust speed (200 l/s), when the ECR surface distance was expanded from 0 to 150 mm, the etch speed decreased from 300 to 100 nm/min. On the other hand, for etching with a high speed exhaust of 500 l/s, even with an ECR surface distance as great as 150 mm, a 300 nm/min etch speed was obtained; and furthermore, when the distance was shortened, the etch speed increased to 1000 nm/min or more. That is, it was discovered that, even when the ECR surface distances are to some extent long due to the high speed exhaust etching, it was possible to obtain an etch speed equal to or greater than those obtained with shorter ECR surface distances.

Problems associated with closely positioned ECR surfaces are that the reaction products from the wafer are re-dissociated, allowing redeposition on the wafer surface, because the dissociation efficiency of plasma is high in the ECR area. This may lead to deterioration of the etched shape and contamination of the surface. Also, when the ECR distance is reduced, the homogeneity of the etching may be decreased. When the amount of reaction products adsorbed into the wafer was examined by surface analysis it was found, as shown in Fig. 24, that when the exhaust speed is 500 l/s, the adsorption amount increases as the ECR surfaces distance is shortened. When the exhaust speed is low (200 l/s) the exhaust speed of reaction products is slow, so that even if the ECR surface distance is to some extent long and the redissociation is less, the amount adsorbed into the wafer increases. Therefore, for high speed etching with low contamination due to lesser adsorption of reaction products, it is better to have the ECR surface distance lengthened somewhat and to exhaust at high speed.

Example 8

Using the high speed exhaust microwave plasma etching device shown in Fig. 1, Al etching was performed at 1 to 10 mTorr gas pressure. Etching conditions were: 5 mTorr $Cl_2$ gas pressure, 500 W microwave power, 20 W RF bias at 2 MHz, and 0°C wafer temperature. Fig. 25 shows the relationship between exhaust speed and Al etch speed. The gas flow rate is the gas pressure multiplied by the exhaust speed. At 500 l/s or more, the etch speed greatly increased. In this invention, the exhaust speed is 800 l/s or above. On the other hand, Fig. 26 shows the dependency of undercut amount on exhaust speed. Since the gas pressure was 5 mTorr, which is high, undercutting occurred easily, and especially tended to increase at 1300 l/s or more exhaust speed. The reasons for the smaller undercut amounts at 1300 l/s or less exhaust speed were that the reaction products residence time was long, and these were deposited on the lateral surfaces of the pattern, which prevented lateral etching. Therefore, during etching, when undercutting could not be controlled without using lateral deposits, and a high etch speed was required, 500 l/s was appropriate for controlling undercut amounts of 0.1 μm or less at a high etch speed of 1000 nm/min or more. Similar etching tendencies were also obtained at 1 to 10 mTorr pressure; and the exhaust speeds, which satisfied the requirement for 0.1 μm or less undercut amount at the high etch speed at 1000 nm/min or more, were between 500 l/s and 1300 l/s. Incidentally, the gas residence time was 300 msec at 500 l/s.

Example 9

Using the high speed exhaust microwave plasma etching device shown in Fig. 1 and $BCl_3$, Al etching was performed. Etching conditions were: 4 mTorr $BCl_3$ gas pressure, 500 W microwave power, 20 W RF bias at 2 MHz, and 20°C wafer temperature. Fig. 27 shows the dependency of Al undercut amounts on gas pressure. The exhaust speed was 800 l/s. The undercut amount greatly decreased at 5 mTorr or less, becoming 0.1 μm or less. Compared to etching using $Cl_2$, $BCl_3$ decreased the amount of undercut at higher gas pressures. The reason for this is that $BCl_3$ was deposited on the lateral surfaces of the pattern and was effective in protecting the lateral surfaces. Fig. 28 shows the exhaust speed dependency of the Al etch speeds microloading (pattern size dependency; here referring to the etch speed ratio of 0.2 μm (a) and 10 μm (b) for recessed patterns a and b). Microloading decreased as exhaust speed increased, becoming 0.9 or more at 800 l/s or more, which could be used for practical applications. The reason why the microloading decreases as the exhaust speed increases is because etching reactive particles can be sufficiently supplied even in small recesses due to the increase in exhaust speed. Therefore, in order to perform Al etching using $BCl_3$, while controlling undercutting and microloading, it was discovered that it is better for the gas pressure to be 5 mTorr or less and for the exhaust speed to be 800 l/s or more. Microloading relates to over-etching amounts required for finishing the etching of small recesses. In this case, a 0.9 or more microloading does not present any big problem for practical use, so that there is no need to increase the exhaust speed unnecessarily.

Example 10

Using the high speed exhaust microwave plasma etching device shown in Fig. 1 and the reactive ion etching device shown in Fig. 29 (for a description of Fig. 29, reference can be made to Fig. 8 where the same parts have the same numbers. In Fig. 29 there are a plurality of pumps 11), Al etching was performed. Etching conditions for the microwave etching device were: $Cl_2$ gas, 500 W microwave power, 20 W RF bias at 2 MHz and 10°C wafer temperature. Etching conditions for the reactive ion etching device were: 500 W RF power, $Cl_2$ gas, and 10°C wafer temperature. Fig. 30 shows the relationship between Al etch speed and gas pressure. The exhaust speed was set at 500 l/s (Comparative example). Microwave etching allows etching at low gas pressure, so that undercutting fell to 0.1 μm or less at 4 mTorr, and the etch speed was 1000 nm/min. Reactive ion etching does not allow etching at low gas pressures, so that undercutting was 0.2 μm at 10 mTorr, and the etch speed was 300 nm/min. That is, compared to reactive ion etching, microwave etching enables high speed etching with fewer undercuts at low gas pressures. On the other hand, Fig. 31 shows the relationship between Al etch speed and the exhaust speed. The gas pressure was 4 mTorr. As the exhaust speed increased, the Al etch speed in the microwave etching obviously increased compared to that in the reactive ion etching. In microwave etching, the surface reaction speed is faster than that in reactive ion etching, being the so-called reaction rate-determining state, so that the etching reaction is promoted when the supply of etching reactive particles increases due to increases in exhaust speed. Especially, at 500 l/s or more, particularly at 800 l/s or more, the speed tended toward saturation. On the other hand, reactive ion etching is in the reaction rate-determining state, with a slow surface reaction speed, so that even if the supply of etching reactive particles is increased by increasing the exhaust speed, the etch speed increases only a little. Therefore, in using microwave plasma etching, in order to prevent undercutting at low gas pressures and increase the etch speed at high exhaust speeds, it is appropriate to set the gas pressure at 4 mTorr or less, and the exhaust speed at 500 l/s or more. In this invention, the exhaust speed is 800 l/s or more. As the gas pressure goes down, undercutting become less; but at 0.5 mTorr or less, Al etch speed greatly drops, becoming 300 nm/min or less, which is not so suitable for practical application.

Example 11

Using the high speed exhaust microwave plasma etching device shown in Fig. 1 and the reactive ion etching device shown in Fig. 29, Al etching was performed. Etching conditions for the microwave etching device were: 4 mTorr $Cl_2$ gas pressure, 500 W microwave power, 20 W RF bias at 2 MHz, and 10°C wafer temperature. Etching conditions for the reactive ion etching device were: 500 W RF power, 10 mTorr $Cl_2$ gas pressure, and 10°C wafer temperature. Fig. 32 shows the relationship between Al etch speed and gas residence time. Here, the gas flow rate was variable. When there was a reduction in residence time, the Al etch speed tended to increase in both etching methods, but with a more obvious increase in the microwave etching method. At a 300 msec residence time, the Al etch speed was 1000 nm/min. Therefore, in order to obtain a 1000 nm/min etch speed with 0.1 μm or less undercutting, a 300 msec or less gas residence time at 4 mTorr or less gas pressure was required.

With this invention as claimed, it is possible, under high vacuum, to prevent or reduce undercutting, achieve a high etch rate at a large gas flow rate and increase the etching speed ratio (selectivity) between the etched material and other materials. As a result, it has become possible to perform with high speed and high anisotropy the etching of Si grooves and contact holes with high aspect ratios (ratios of pattern width to etching depth). Such grooves and holes require very high anisotropy.

Also, it is possible to prevent undercutting to some degree and improve etch speed and etching selectivity even at 1 mTorr or more gas pressure.

Redeposition of the reaction products is small, which enables reduction in the contamination of the wafer and the device, and reduces abnormalities in the etching shape etc.

This invention as claimed is effectively applied not only to the above-mentioned etching machines and etching materials but to other machines and materials, such as magnetron discharge RIE and helical resonator discharge RIE machines and aluminum, tungsten, tungsten silicide, copper, GaAs, and Si nitride films.

The use of a large vessel allows a number of 8-inch or larger wafers to be etched simultaneously at an etching speed almost equal to that obtained in the conventional machine, improving the throughput of the dry etching and lowering the cost of semiconductor products.

A batch processing of large-diameter wafers using a large-vessel, high-speed exhaust etching machine has the effect of increasing the throughput in dry etching. The high-speed evacuation makes it possible to shorten the time during which to reduce the residual gas amount below a specified value, thereby improving the process throughput.

## Claims

**1.** A plasma etching method, comprising:

etching a body in a vacuum chamber (1; 111; 201) by means of a gas plasma formed by introducing an etching gas into said chamber and forming the gas plasma from the etching gas, wherein the etched material of the body and the etching gas are such that there is re-deposition of their reaction products on the body,

characterised in that

said vacuum chamber (1; 111; 201) has a total exhaust conductance of more than 2000 l/s, and
during said etching the vacuum chamber is evacuated by means of one or more exhaust pumps at an effective exhaust speed greater than 800 l/s,
wherein said effective exhaust speed ($S_o$) is given by

$$1/S_o = 1/\Sigma S_n + 1/C$$

where
$S_n$ is the exhaust speed of each exhaust pump (where n is the number of exhaust pumps), and
C is the exhaust conductance of the vacuum chamber.

**2.** A plasma etching method as claimed in claim 1 wherein the sample is located at a position other than the Electron Cyclotron Resonance (ECR) point.

**3.** A plasma etching method as claimed in claim 1 or 2 wherein the etching carried out at an etching speed of at least 50 nm/min, and said evacuating of the vacuum chamber is conducted so that the residence time of the gas in the vacuum chamber does not exceed 300 msec.

**4.** A plasma etching method according to claim 3 wherein the etching speed is at least 500 nm/min.

**5.** A plasma etching method according to any one of claims 1 to 4 wherein the gas pressure in the treatment chamber is not more than 0.666 MPa (5 mTorr).

**6.** A plasma etching method according to any one of claims 1 to 5 wherein the effective exhaust speed is at least 1300 l/s.

**7.** A plasma etching method according to any one of claims 1 to 5 wherein the effective exhaust speed is at least 2000 l/s.

**8.** A plasma etching method according to any one of claims 1 to 7 wherein said etched material of the body is selected from Si, $SiO_2$, Al, W, tungsten silicide, Cu, GaAs and silicon nitride.

**9.** A plasma etching method according to any one of claims 1 to 8 wherein during the etching the amount of unreacted reactive gas present in said vacuum chamber is greater than the amount therein of reaction product.

**10.** A plasma etching method according to any one of the preceding claims wherein the etched body is a wafer having a size of at least 15cm (6 inches).

**11.** A plasma etching method according to any one of the preceding claims wherein the etching gas contains chlorine.

## Patentansprüche

1. Plasmaätzverfahren, wobei ein Körper in einer Vakuumkammer (1; 111; 201) mittels eines Gasplasmas geätzt wird, das dadurch entsteht, daß in die Kammer ein Ätzgas geleitet und daraus das Gasplasma gebildet wird, wobei das geätzte Material des Körpers und das Ätzgas so beschaffen sind, daß eine Wiederabscheidung ihrer Reaktionsprodukte auf dem Körper erfolgt,
   dadurch gekennzeichnet,

   daß die Vakuumkammer (1; 111; 201) einen gesamten Absaugfähigkeit von mehr als 2000 ℓ/s aufweist, und daß während des Ätzens die Vakuumkammer mittels einer oder mehrerer Absaugpumpen mit einer effektiven Absauggeschwindigkeit über 800 ℓ/s evakuiert wird,
   wobei die effektive Absauggeschwindigkeit ($S_o$) durch die Gleichung

   $$1/S_o = 1/\Sigma\ S_n + 1/C$$

   gegeben ist, in der
   $S_n$ die Absauggeschwindigkeit jeder Absaugpumpe (mit n = Anzahl der Absaugpumpen) und
   C die Absaugfähigkeit der Vakuumkammer angibt.

2. Plasmaätzverfahren nach Anspruch 1, wobei die Probe an einer vom Elektronenzyklotron-Resonanzpunkt (ECR) verschiedenen Stelle angeordnet wird.

3. Plasmaätzverfahren nach Anspruch 1 oder 2, wobei das Ätzen mit einer Ätzgeschwindigkeit von mindestens 50 nm/min erfolgt und die Evakuierung der Vakuumkammer so durchgeführt wird, daß die Verweilzeit des Gases in der Kammer 300 ms nicht überschreitet.

4. Plasmaätzverfahren nach Anspruch 3, wobei die Ätzgeschwindigkeit mindestens 500 nm/min beträgt.

5. Plasmaätzverfahren nach einem der Ansprüche 1 bis 4, wobei der Gasdruck in der Behandlungskammer nicht größer ist als 0,666 MPa (5 mTorr).

6. Plasmaätzverfahren nach einem der Ansprüche 1 bis 5, wobei die effektive Absauggeschwindigkeit mindestens 1300 ℓ/s beträgt.

7. Plasmaätzverfahren nach einem der Ansprüche 1 bis 5, wobei die effektive Absauggeschwindigkeit mindestens 2000 ℓ/s beträgt.

8. Plasmaätzverfahren nach einem der Ansprüche 1 bis 7, wobei das geätzte Material des Körpers aus den Stoffen Si, $SiO_2$, Aℓ, W, Wolframsilicid, Cu, GaAs und Siliciumnitrid ausgewählt ist.

9. Plasmaätzverfahren nach einem der Ansprüche 1 bis 8, wobei während des Ätzens die in der Vakuumkammer vorhandene Menge an nicht reagiertem Reaktionsgas größer ist als die darin vorhandene Menge an Reaktionsprodukt.

10. Plasmaätzverfahren nach einem der vorhergehenden Ansprüche, wobei der geätzte Körper ein Wafer mit einer Größe von mindestens 15 cm (6 Zoll) ist.

11. Plasmaätzverfahren nach einem der vorhergehenden Ansprüche, wobei das Ätzgas Chlor enthält.

## Revendications

1. Procédé d'attaque chimique au plasma, comportant l'étape consistant à :

   attaquer chimiquement un corps dans une chambre à vide (1 ; 111 ; 201) à l'aide d'un plasma gazeux formé en introduisant un gaz d'attaque chimique dans ladite chambre et en formant le plasma gazeux à partir du gaz d'attaque chimique, le matériau attaqué chimiquement du corps et le gaz d'attaque chimique étant tels qu'il y a un re-dépôt de leurs produits de réaction sur le corps,

caractérisé en ce que

ladite chambre à vide (1 ; 111 ; 201) a une conductance d'évacuation totale de plus de 2 000 l/s, et
pendant ladite attaque chimique, la chambre à vide est mise sous vide à l'aide d'une ou de plusieurs pompes d'évacuation à une vitesse d'évacuation efficace supérieure à 800 l/s,
ladite vitesse d'évacuation efficace ($S_0$) étant donnée par

$$1/S_0 = 1/\Sigma S_n + 1/C$$

où

$S_n$ est la vitesse d'évacuation de chaque pompe d'évacuation (où n est le nombre de pompes d'évacuation), et
C est la conductance d'évacuation de la chambre à vide.

**2.** Procédé d'attaque chimique au plasma selon la revendication 1, dans lequel l'échantillon est situé à une position différente du point de Résonance Gyromagnétique (ECR).

**3.** Procédé d'attaque chimique au plasma selon la revendication 1 ou 2, dans lequel l'attaque chimique est effectuée à une vitesse d'attaque chimique d'au moins 50 nm/min, et ladite mise sous vide de la chambre à vide est effectuée de sorte que le temps de séjour du gaz dans la chambre à vide ne dépasse pas 300 ms.

**4.** Procédé d'attaque chimique au plasma selon la revendication 3, dans lequel la vitesse d'attaque chimique est d'au moins 500 nm/ min.

**5.** Procédé d'attaque chimique au plasma selon l'une quelconque des revendications 1 à 4, dans lequel la pression gazeuse dans la chambre de traitement n'est pas supérieure à 0,666 Mpa (5 mTorr).

**6.** Procédé d'attaque chimique au plasma selon l'une quelconque des revendications 1 à 5, dans lequel la vitesse d'évacuation efficace est d'au moins 1 300 l/s.

**7.** Procédé d'attaque chimique au plasma selon l'une quelconque des revendications 1 à 5, dans lequel la vitesse d'évacuation efficace est d'au moins 2 000 l/s.

**8.** Procédé d'attaque chimique au plasma selon l'une quelconque des revendications 1 à 7, dans lequel ledit matériau attaqué chimiquement du corps est sélectionné parmi Si, $SiO_2$, Al, W, siliciure de tungstène, Cu, GaAs et nitrure de silicium.

**9.** Procédé d'attaque chimique au plasma selon l'une quelconque des revendications 1 à 8, dans lequel pendant l'attaque chimique, la quantité de gaz réactif n'ayant pas réagi présente dans ladite chambre à vide est supérieure à la quantité à l'intérieur du produit de réaction.

**10.** Procédé d'attaque chimique au plasma selon l'une quelconque des revendications précédentes, dans lequel le corps attaqué chimiquement est une tranche ayant une dimension d'au moins 15 cm (6 pouces).

**11.** Procédé d'attaque chimique au plasma selon l'une quelconque des revendications précédentes, dans lequel le gaz d'attaque chimique contient du chlore.

FIG. 1

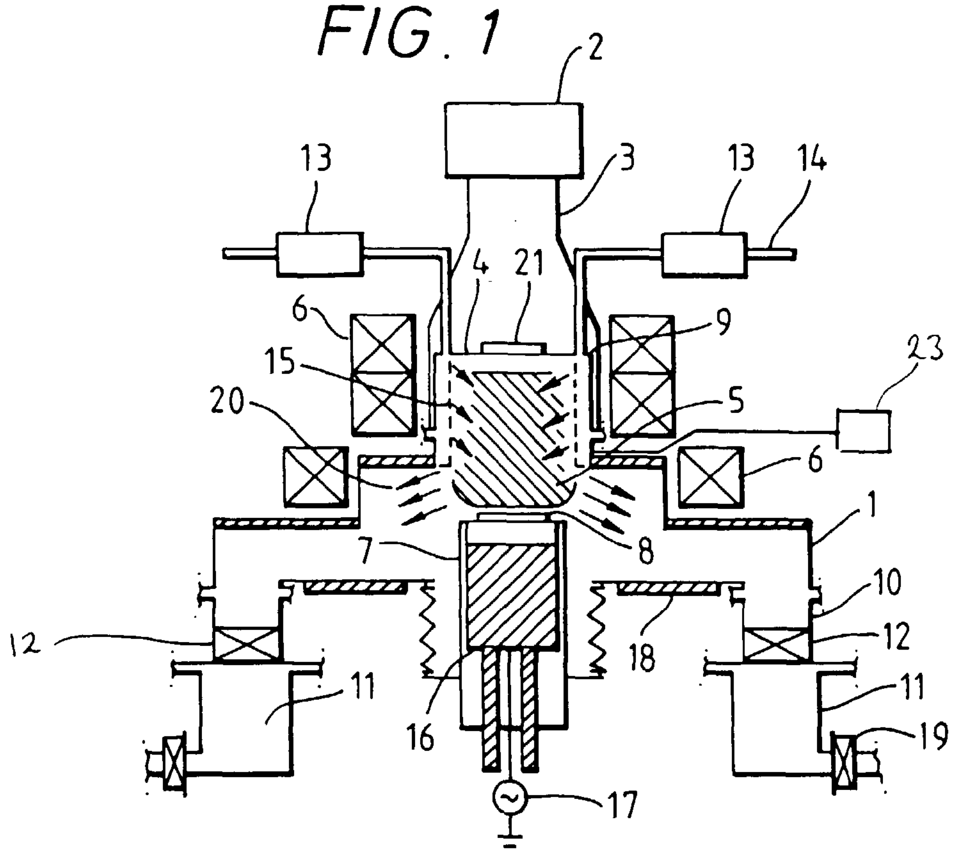
2
3
13
13
14
4
21
6
9
15
5
20
23
6
1
7
8
10
12
12
18
11
11
16
19
17

FIG. 2

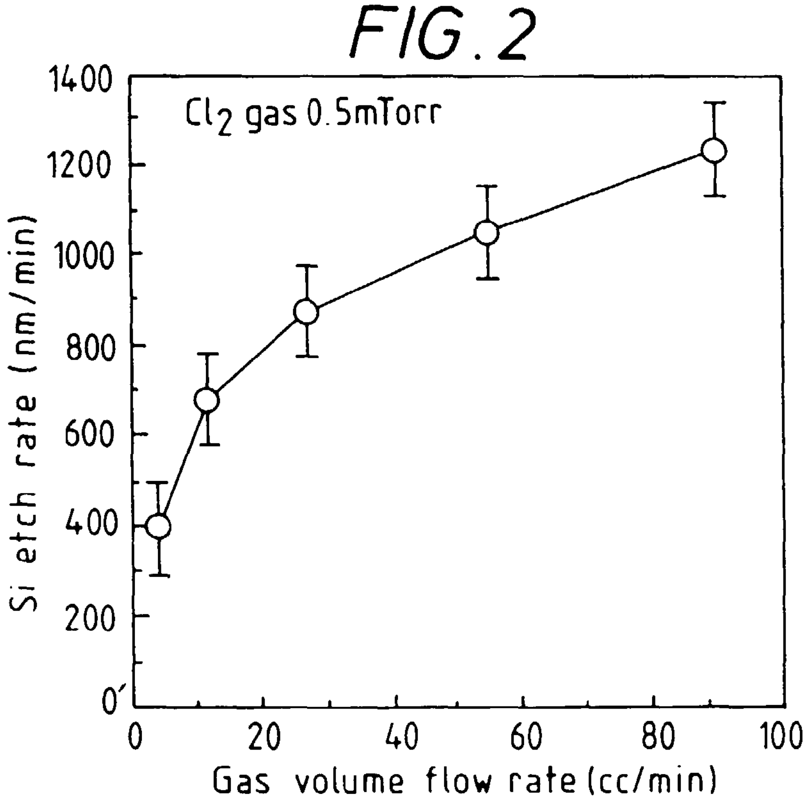
Cl$_2$ gas 0.5mTorr
Si etch rate (nm/min)
1400
1200
1000
800
600
400
200
0
0
20
40
60
80
100
Gas volume flow rate (cc/min)

FIG.3

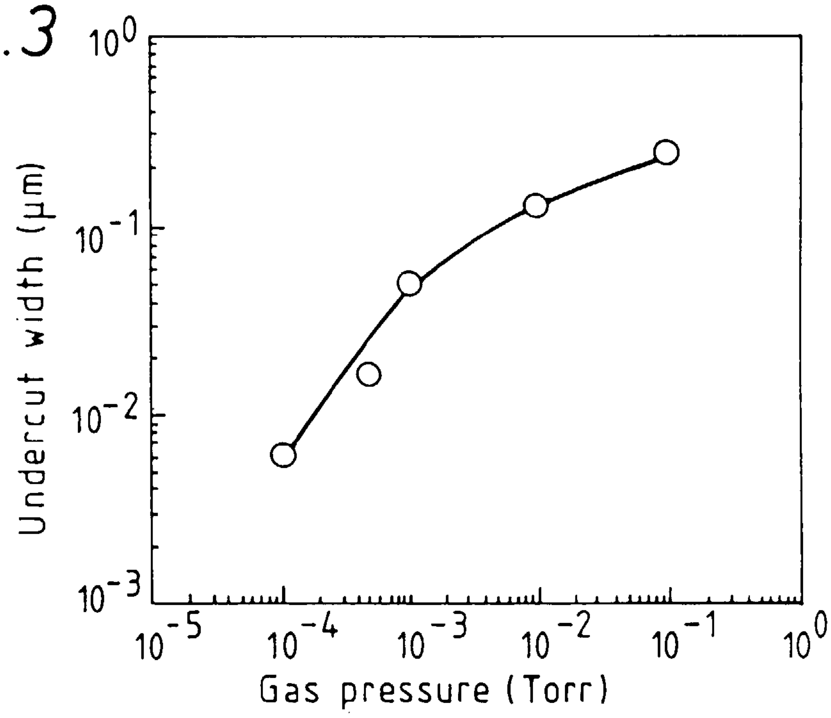
$10^0$
$10^{-1}$
$10^{-2}$
$10^{-3}$
Undercut width (μm)
$10^{-5}$
$10^{-4}$
$10^{-3}$
$10^{-2}$
$10^{-1}$
$10^0$
Gas pressure (Torr)

FIG.4

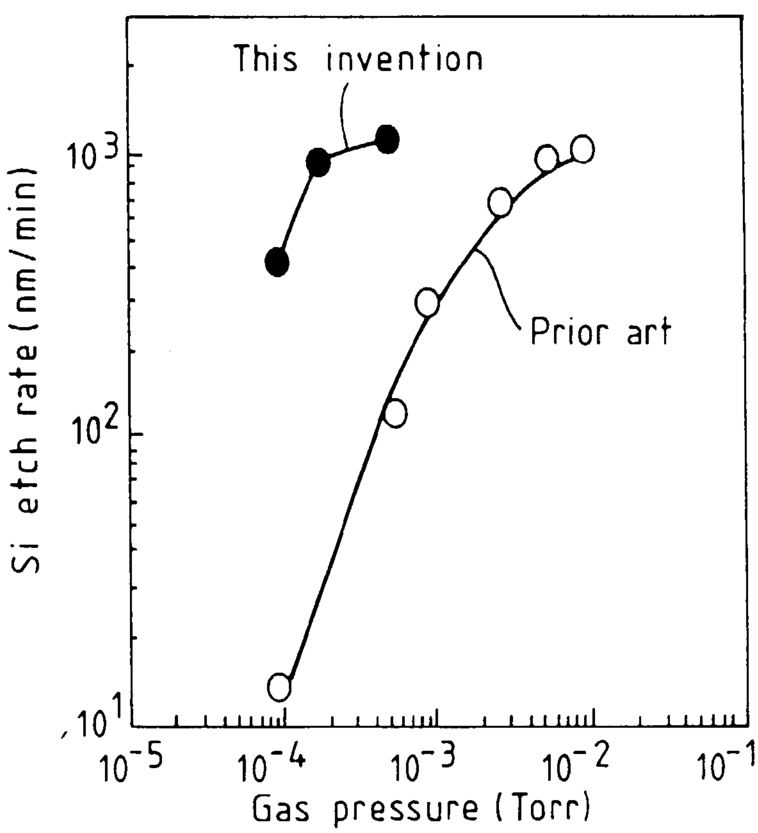
This invention
Prior art
$10^3$
$10^2$
$10^1$
Si etch rate (nm/min)
$10^{-5}$
$10^{-4}$
$10^{-3}$
$10^{-2}$
$10^{-1}$
Gas pressure (Torr)

FIG. 5

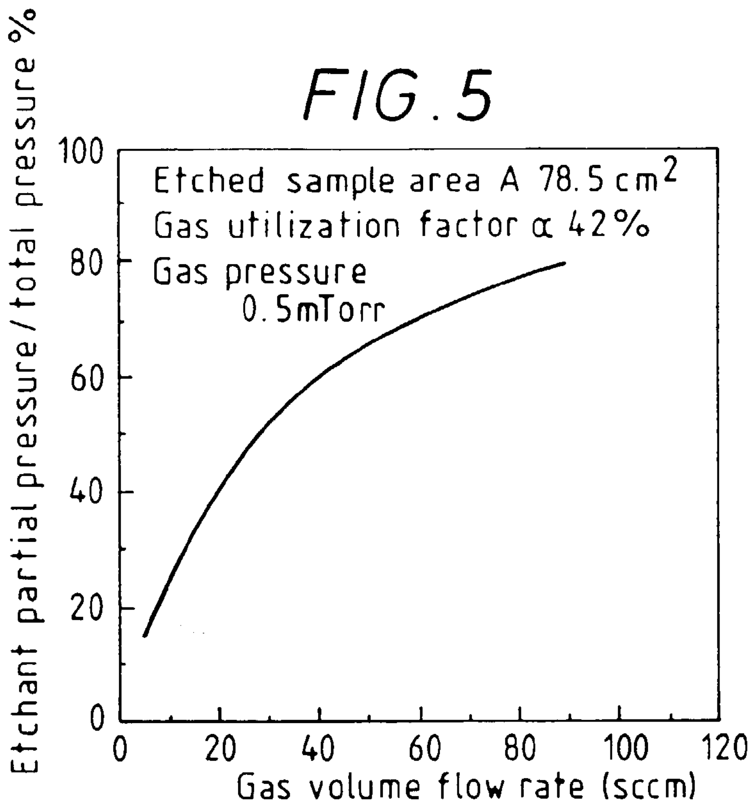
Etched sample area A 78.5 cm2
Gas utilization factor α 42%
Gas pressure 0.5mTorr
Etchant partial pressure / total pressure %
100
80
60
40
20
0
0
20
40
60
80
100
120
Gas volume flow rate (sccm)

FIG. 6

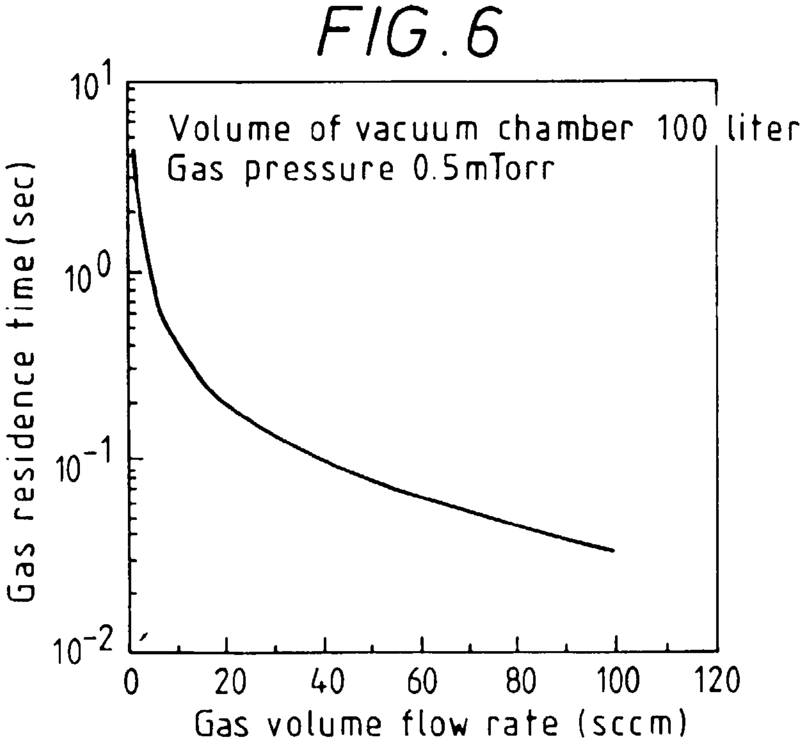
Volume of vacuum chamber 100 liter
Gas pressure 0.5mTorr
Gas residence time (sec)
10^1
10^0
10^-1
10^-2
0
20
40
60
80
100
120
Gas volume flow rate (sccm)

FIG. 7

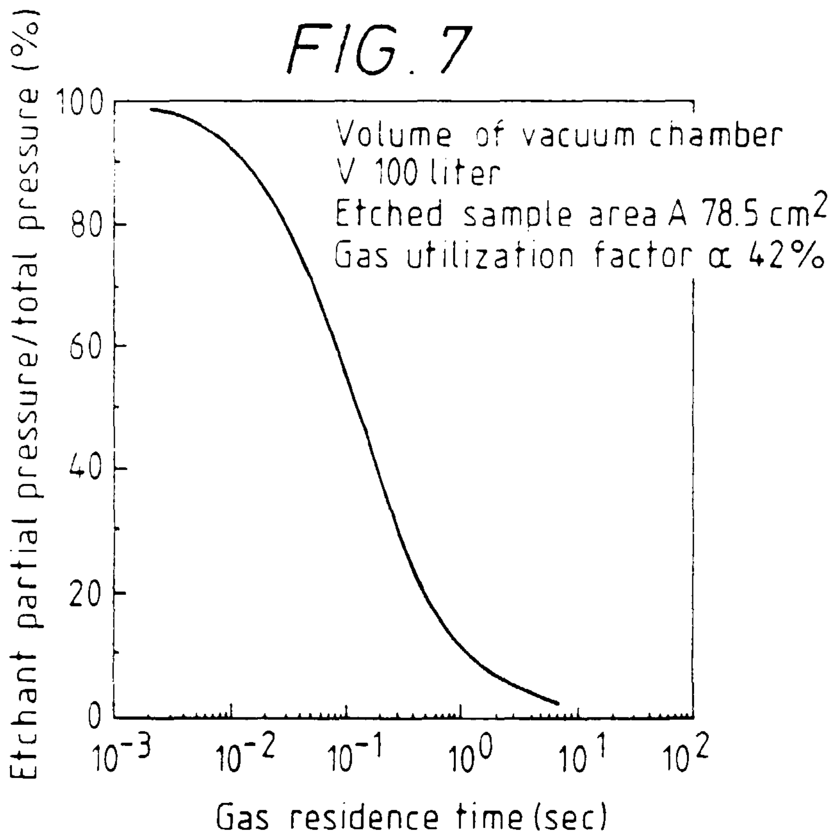
Etchant partial pressure/total pressure (%)
100
80
60
40
20
0
Volume of vacuum chamber
V 100 liter
Etched sample area A 78.5 cm2
Gas utilization factor α 42%
10-3
10-2
10-1
100
101
102
Gas residence time (sec)

FIG. 8

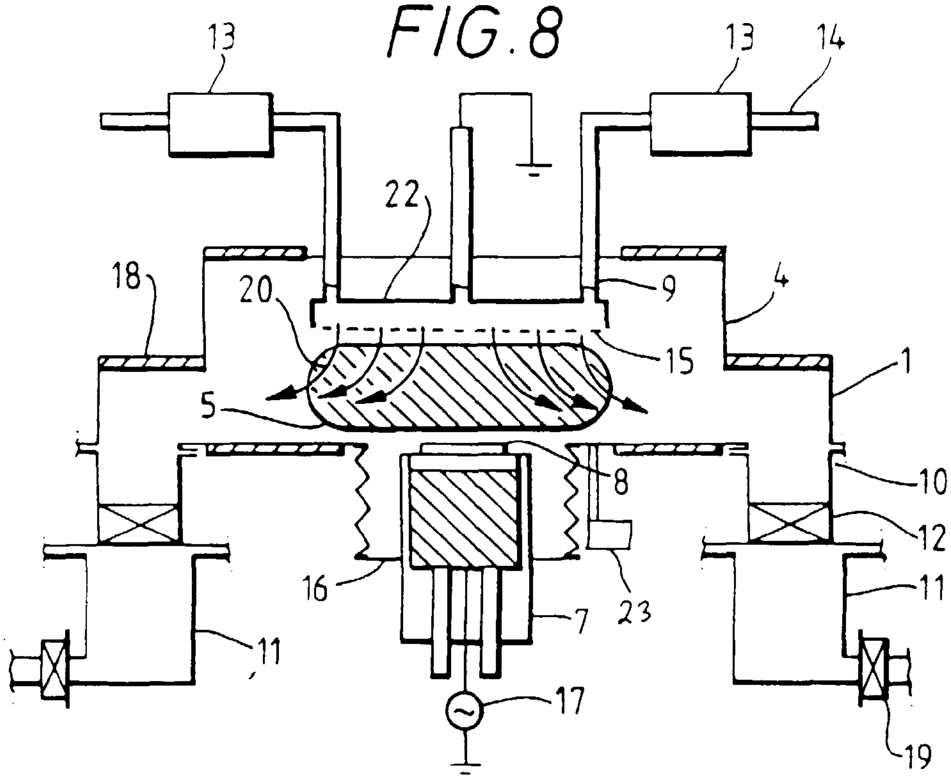
13
13
14
22
18
20
9
4
15
1
5
8
10
12
16
11
7
23
11
17
19

FIG. 9

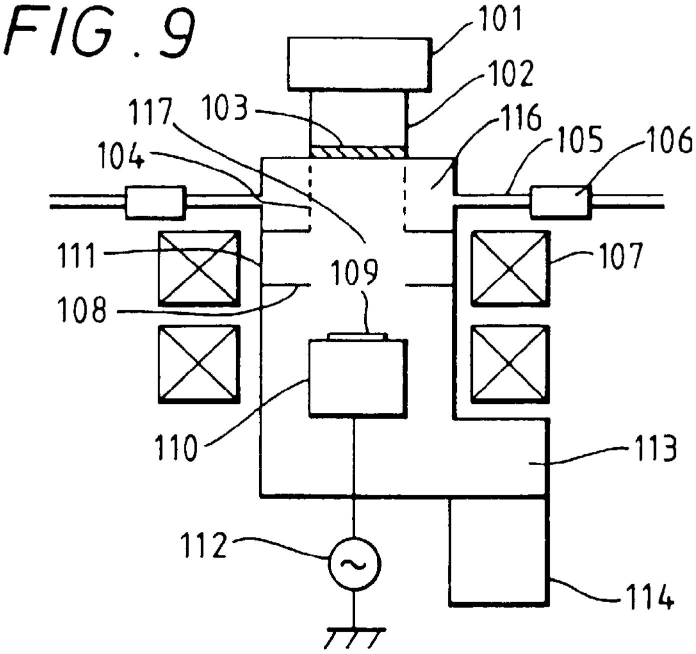


FIG. 10

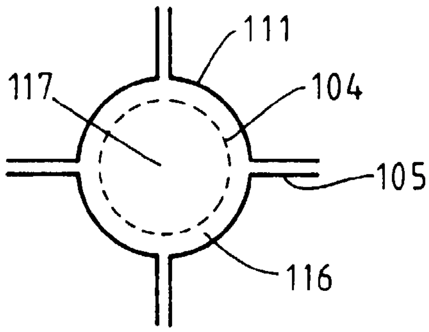


FIG. 11

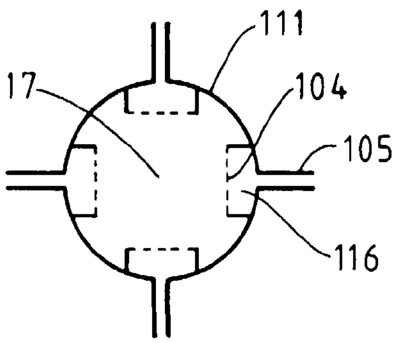

FIG. 12

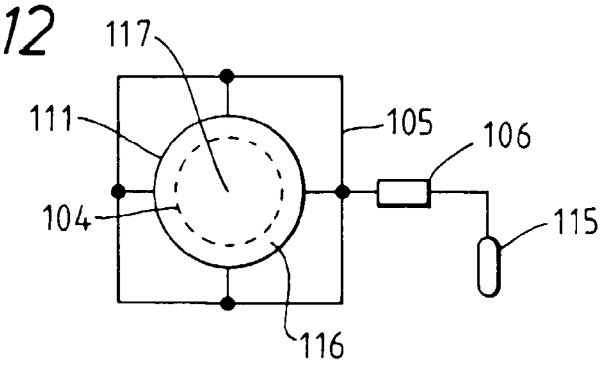


FIG. 13

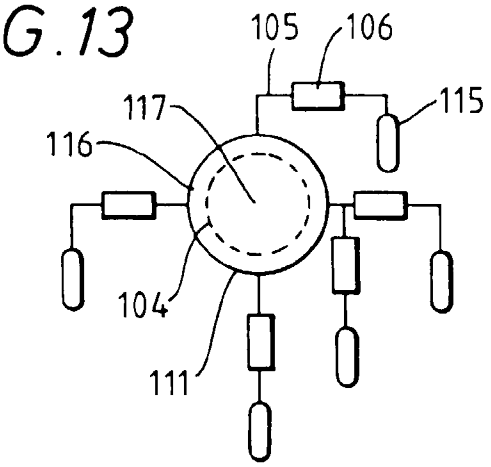


FIG. 14

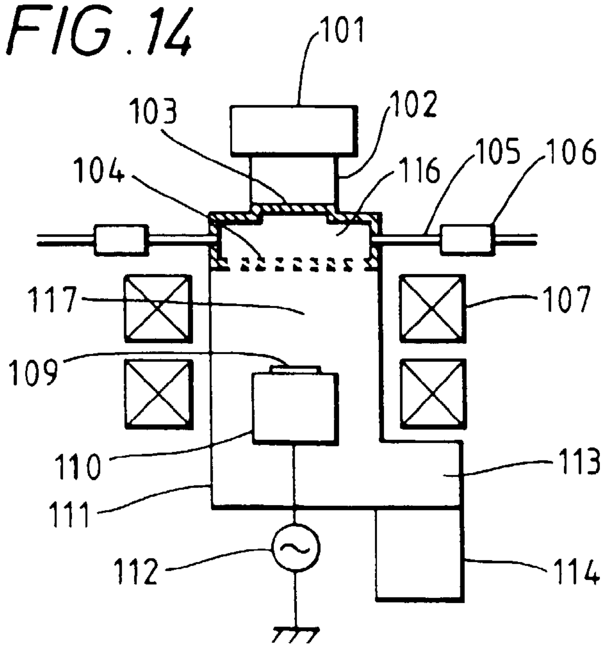

FIG. 15

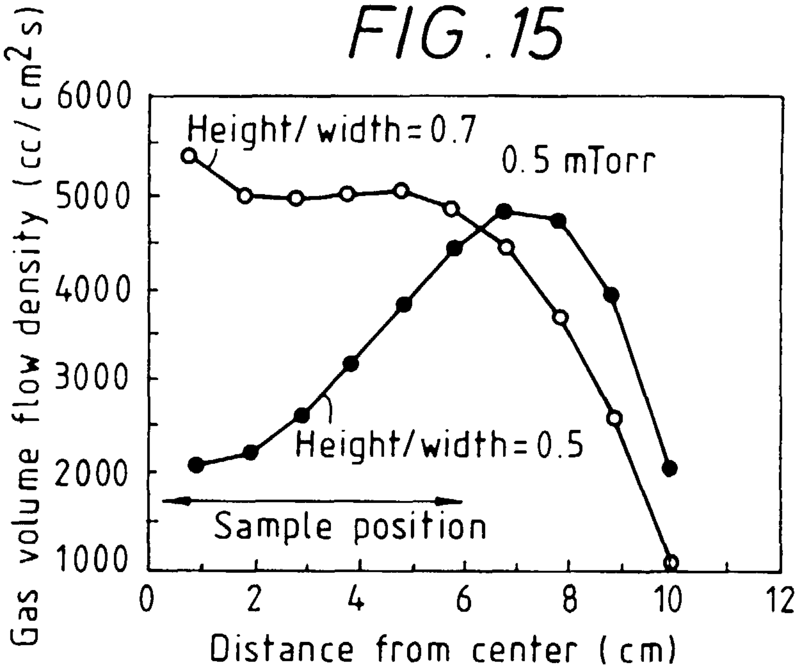
6000
5000
4000
3000
2000
1000
Gas volume flow density (cc/cm²s)
0
2
4
6
8
10
12
Distance from center (cm)
Height/width=0.7
0.5 mTorr
Height/width=0.5
Sample position

FIG. 16

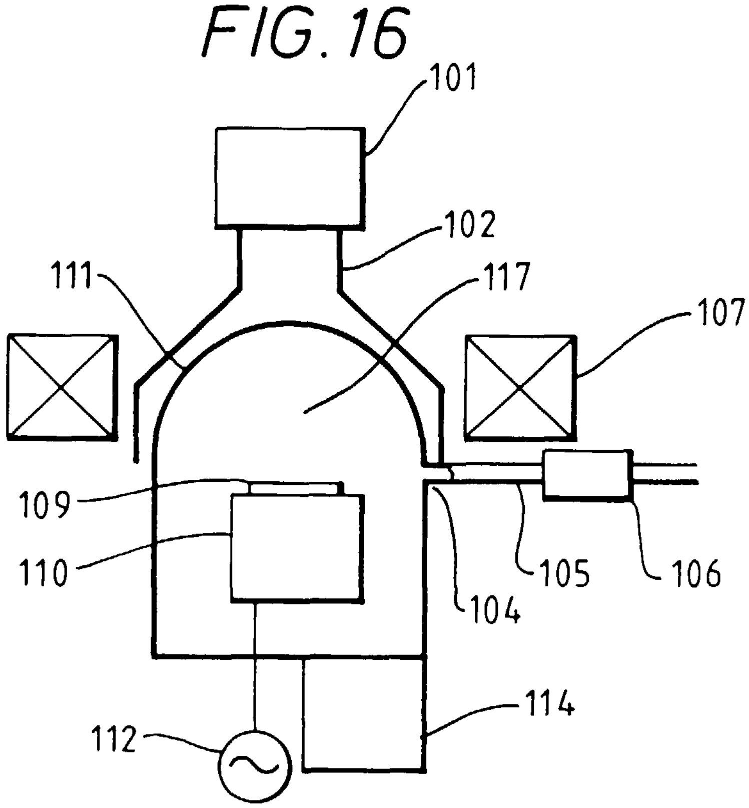
101
102
111
117
107
109
110
105
106
104
112
114

FIG. 17

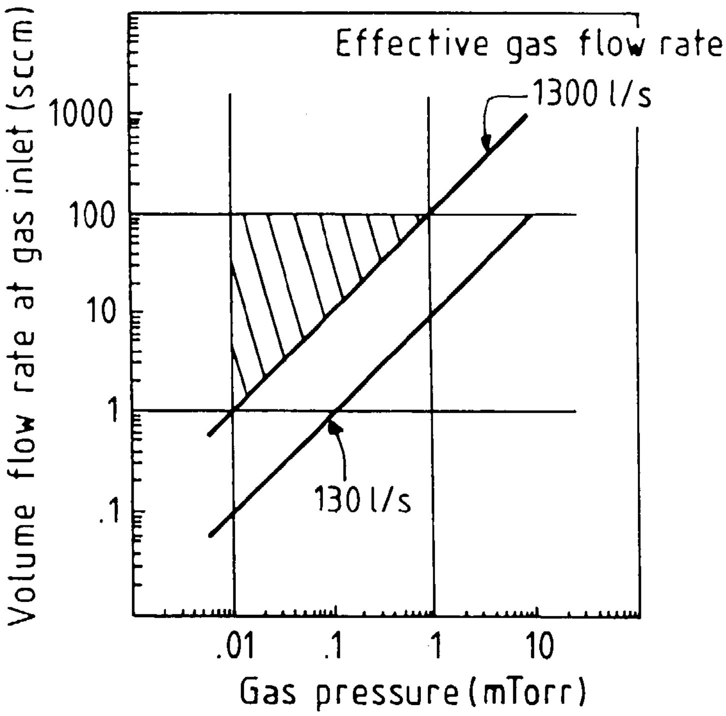
Effective gas flow rate
1300 l/s
130 l/s
Volume flow rate at gas inlet (sccm)
1000
100
10
1
.1
.01
.1
1
10
Gas pressure (mTorr)

FIG. 18

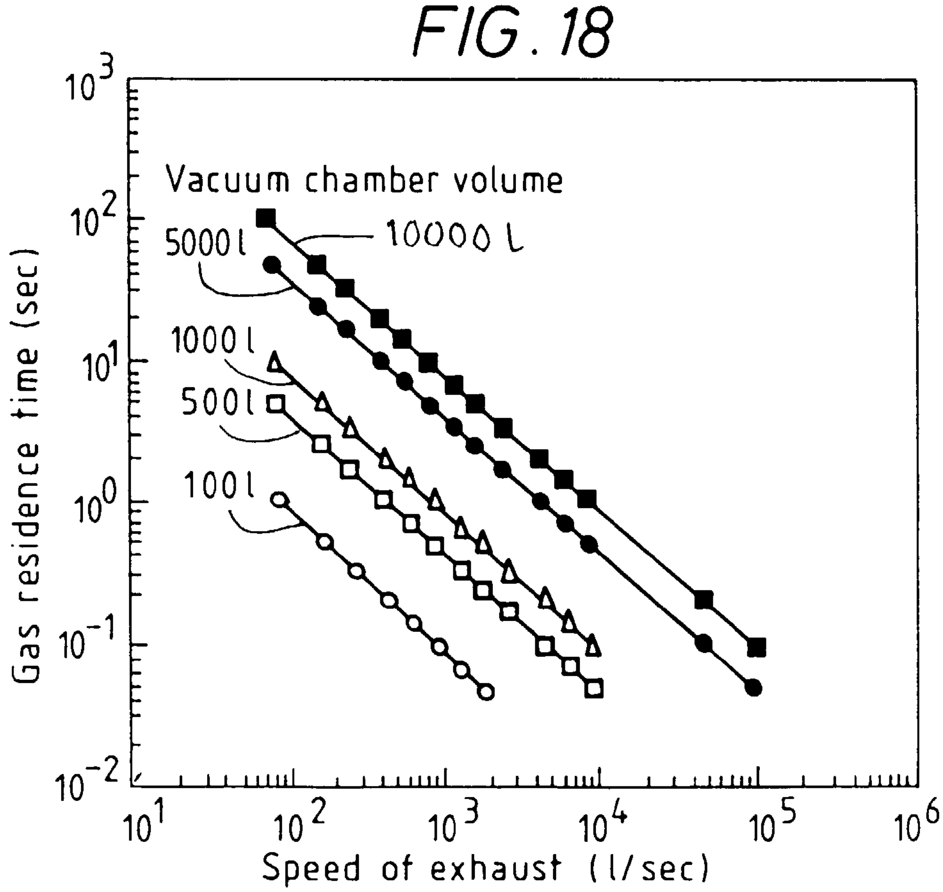
Vacuum chamber volume
5000 l
10000 L
1000 l
500 l
100 l
Gas residence time (sec)
$10^3$
$10^2$
$10^1$
$10^0$
$10^{-1}$
$10^{-2}$
$10^1$
$10^2$
$10^3$
$10^4$
$10^5$
$10^6$
Speed of exhaust (l/sec)

FIG. 19a

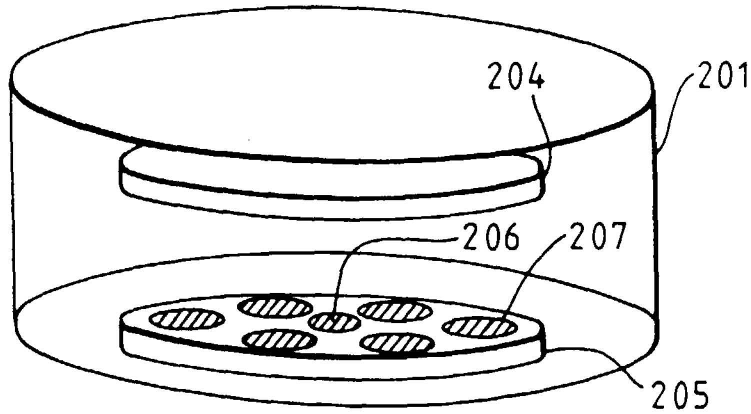


FIG.19b

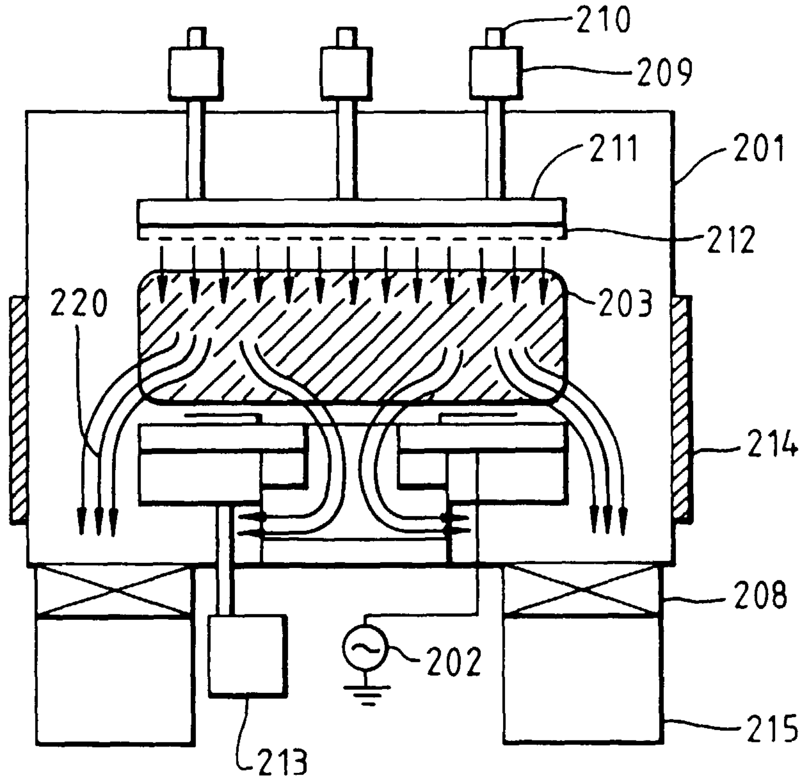

FIG. 20

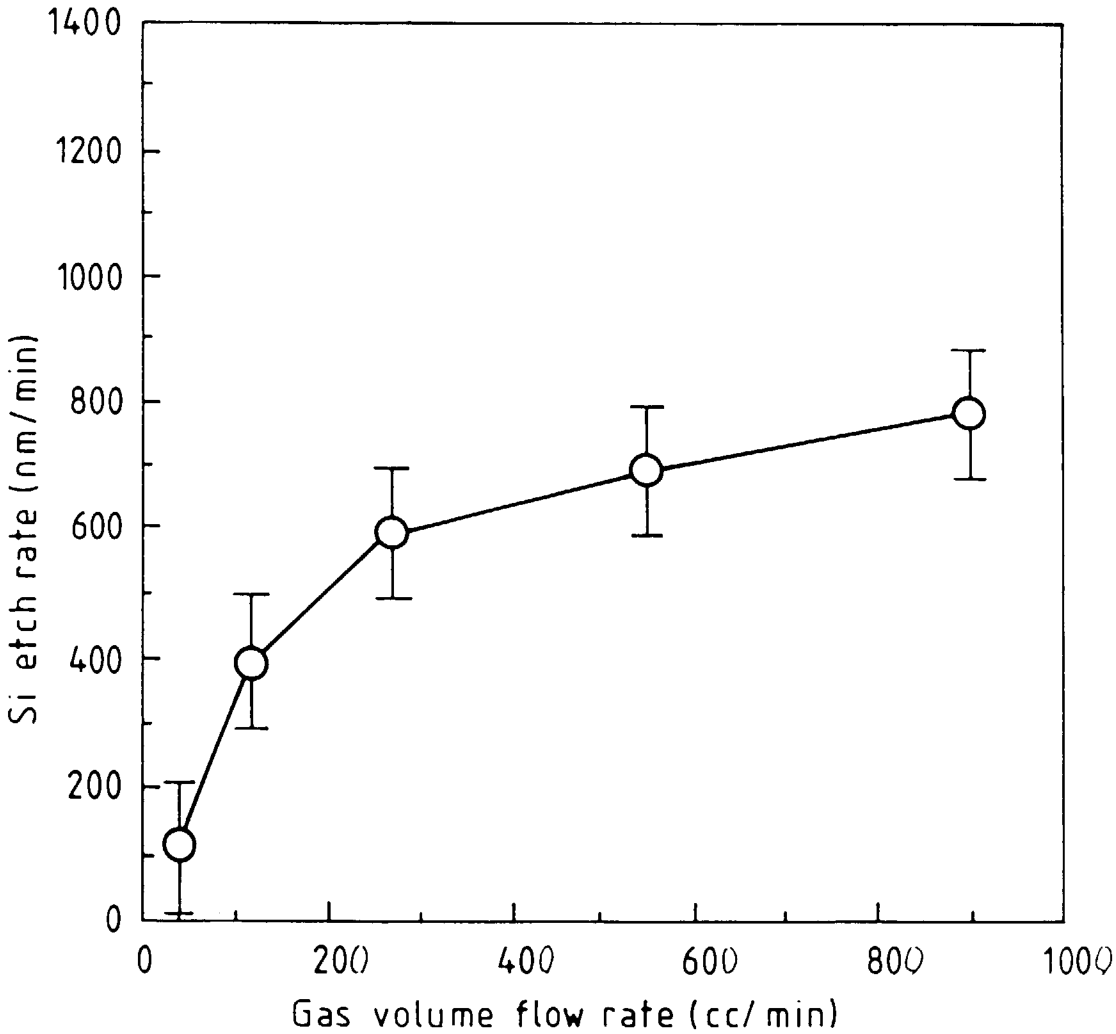
1400
1200
1000
800
600
400
200
0
Si etch rate (nm/min)
0
200
400
600
800
1000
Gas volume flow rate (cc/ min)

FIG. 21a

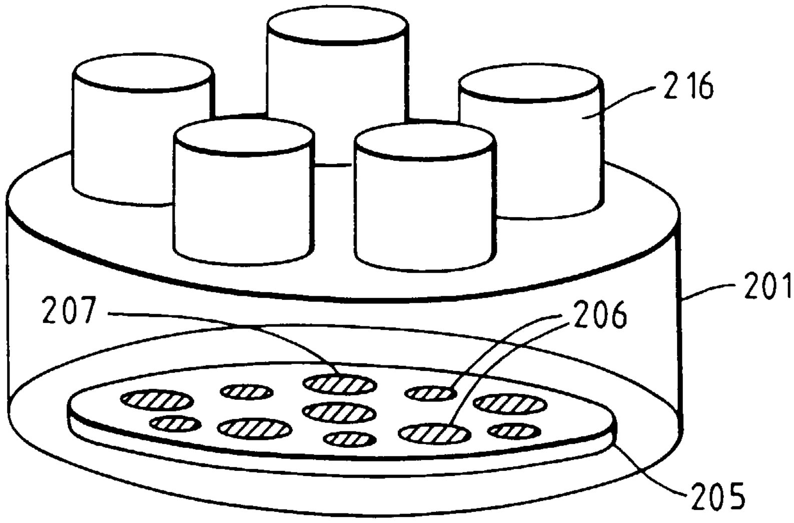


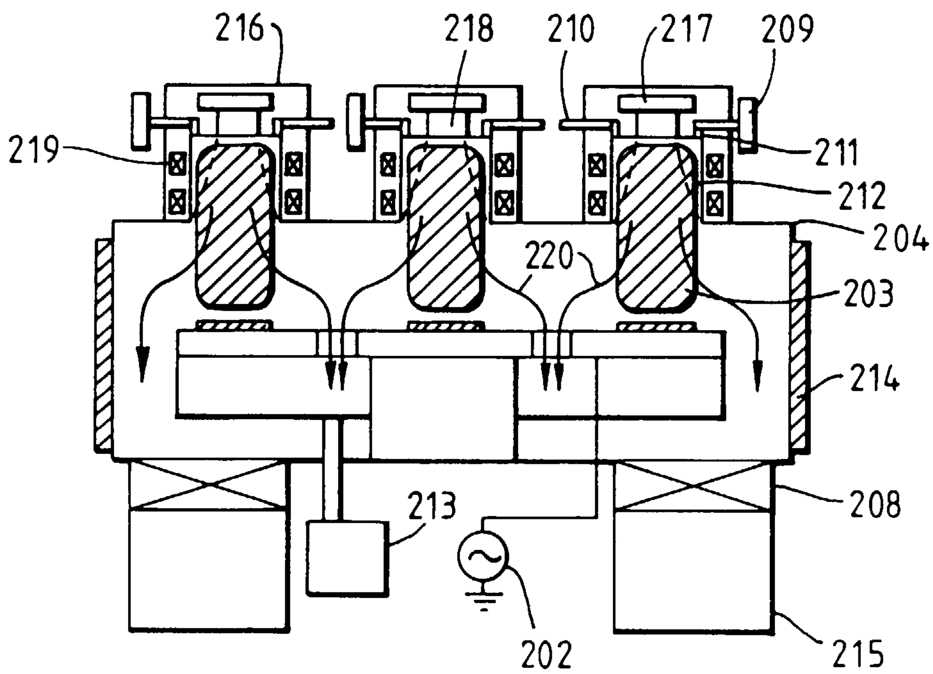


FIG. 21b

FIG. 22

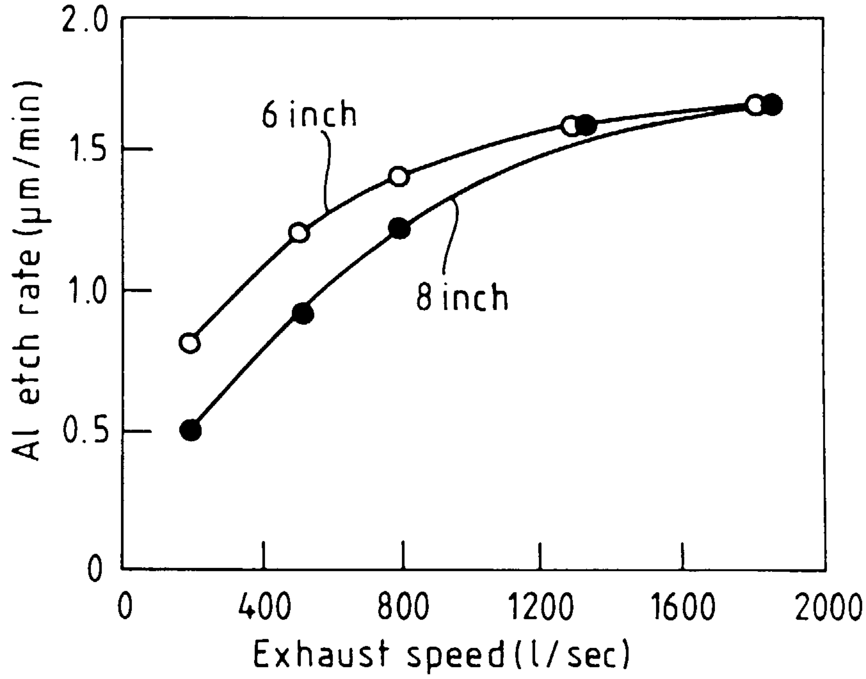
6 inch
8 inch
2.0
1.5
1.0
0.5
0
Al etch rate (μm/min)
0
400
800
1200
1600
2000
Exhaust speed (l/sec)

FIG. 23

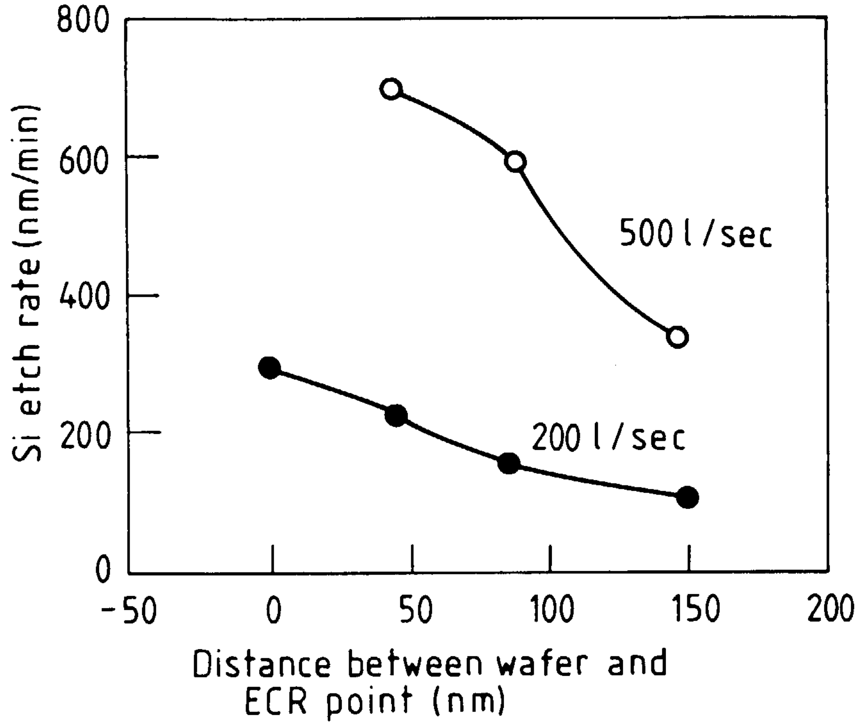
800
600
400
200
0
Si etch rate (nm/min)
500 l/sec
200 l/sec
-50
0
50
100
150
200
Distance between wafer and ECR point (nm)

FIG. 24

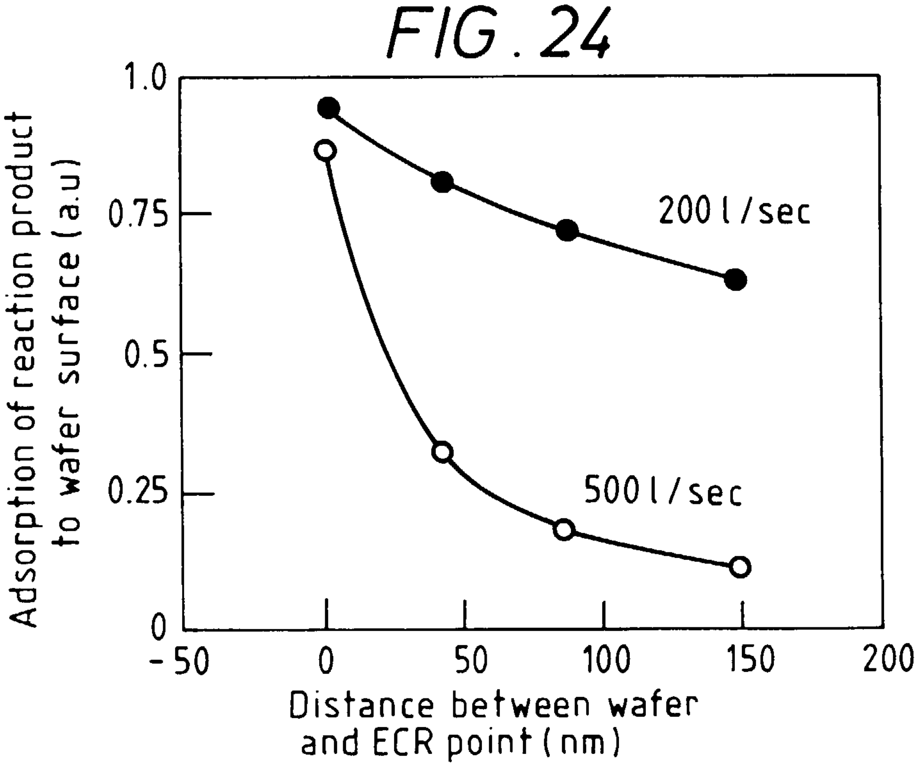
1.0
0.75
0.5
0.25
0
Adsorption of reaction product to wafer surface (a.u)
200 l/sec
500 l/sec
-50
0
50
100
150
200
Distance between wafer and ECR point (nm)

FIG. 25

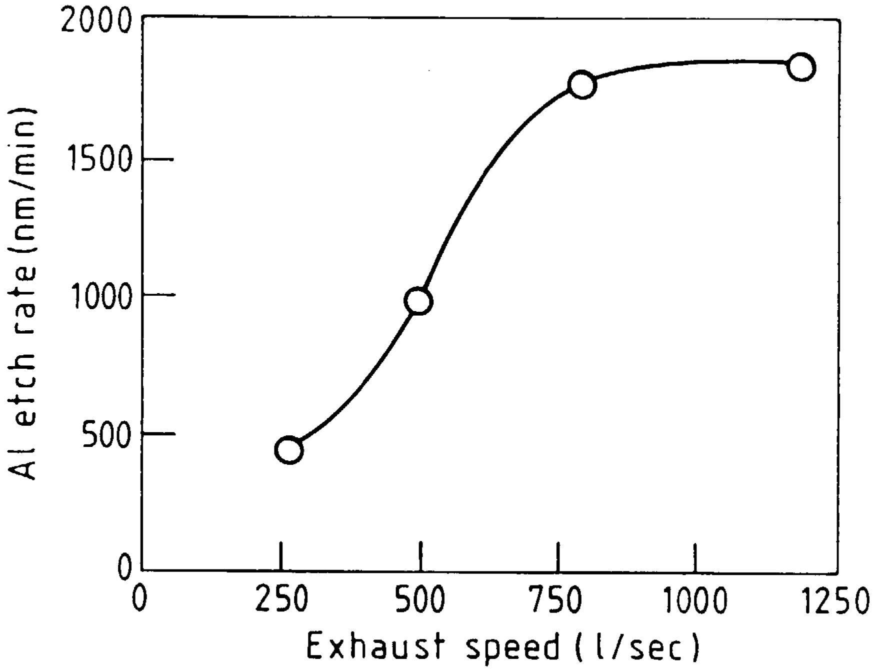
2000
1500
1000
500
0
Al etch rate (nm/min)
0
250
500
750
1000
1250
Exhaust speed ( l/sec )

FIG. 26

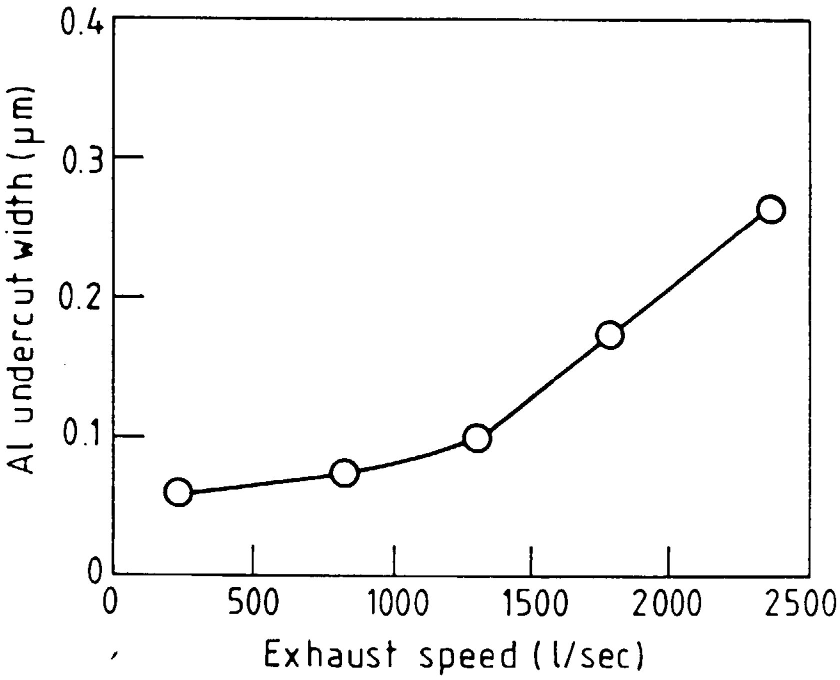
0.4
0.3
0.2
0.1
0
Al undercut width (μm)
0
500
1000
1500
2000
2500
Exhaust speed ( l/sec )

FIG. 27

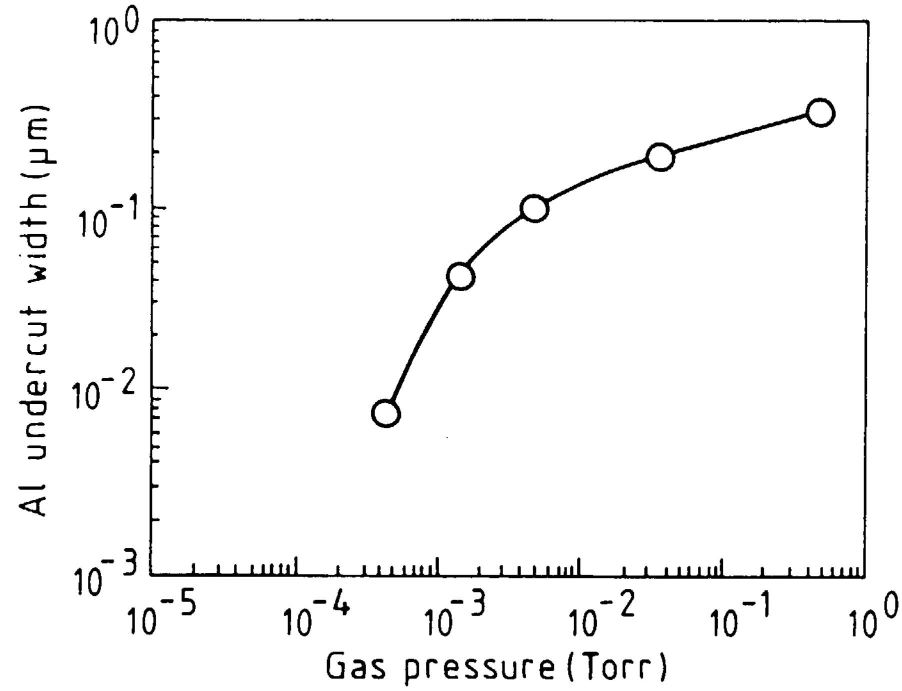

Al undercut width (μm)
10^0
10^-1
10^-2
10^-3
10^-5
10^-4
10^-3
10^-2
10^-1
10^0
Gas pressure (Torr)


FIG. 28

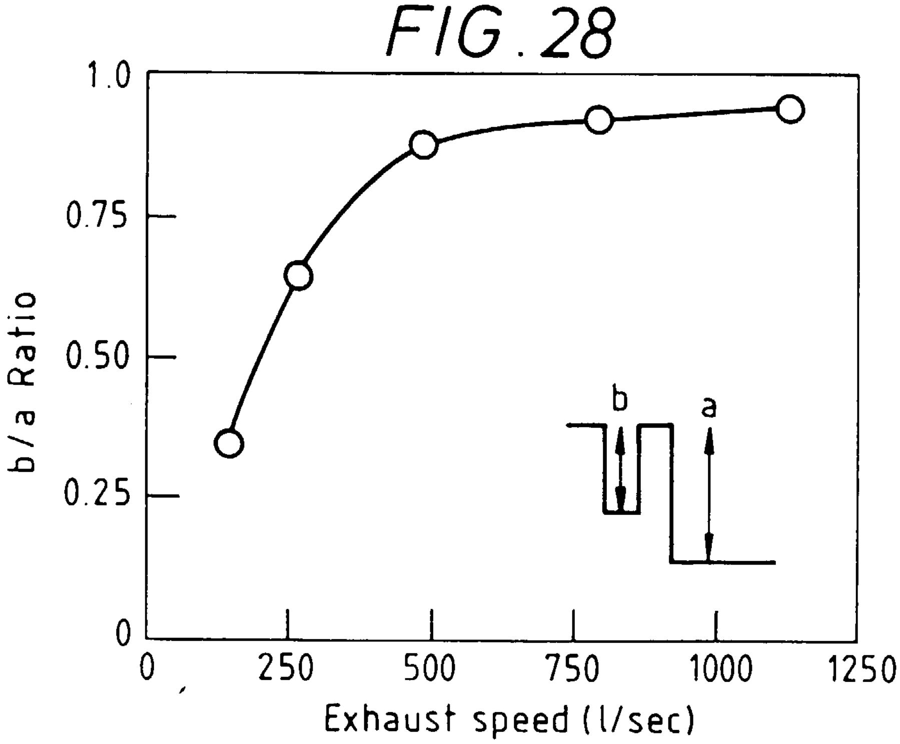

b/a Ratio
1.0
0.75
0.50
0.25
0
250
500
750
1000
1250
Exhaust speed (l/sec)
b
a

FIG. 29

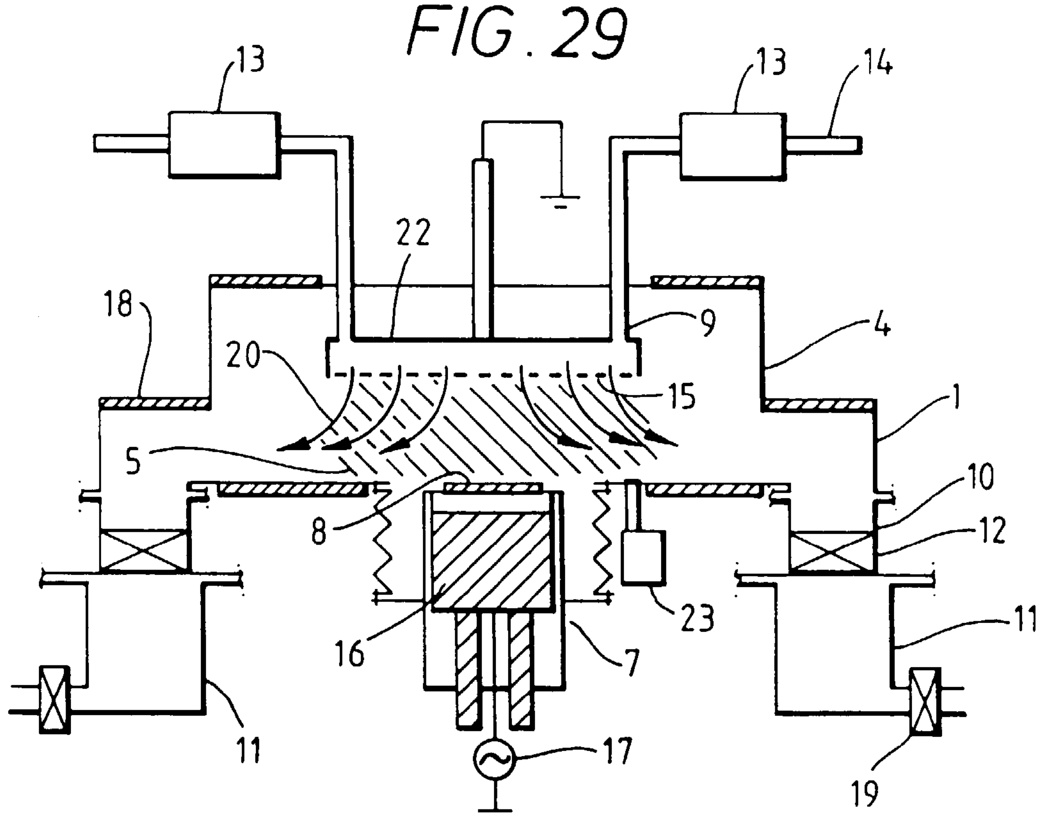
13
13
14
22
18
9
4
20
15
1
5
10
8
12
23
11
16
7
11
17
19

FIG. 32

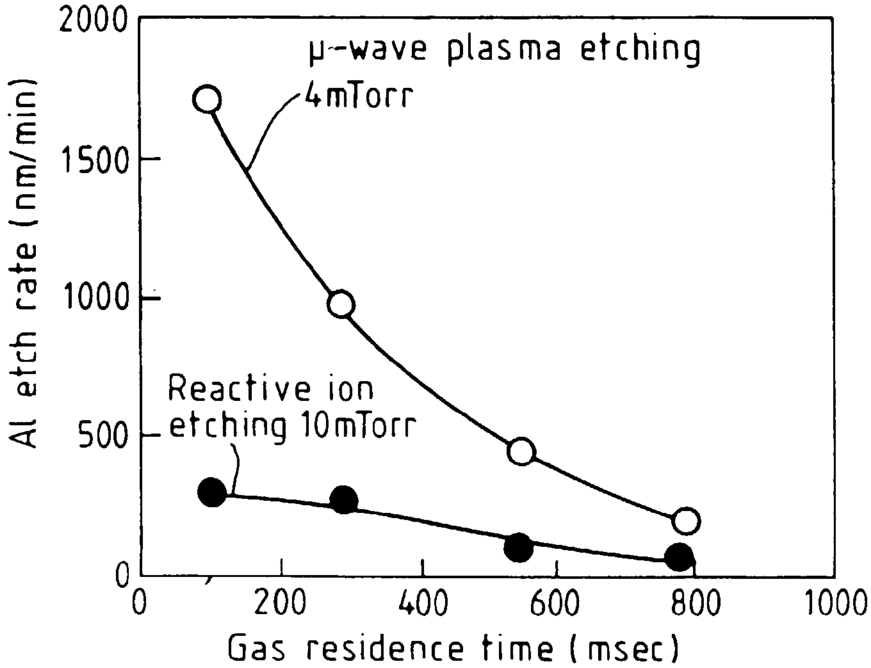
μ-wave plasma etching
4mTorr
Reactive ion
etching 10mTorr
Al etch rate (nm/min)
2000
1500
1000
500
0
0
200
400
600
800
1000
Gas residence time (msec)

FIG. 30

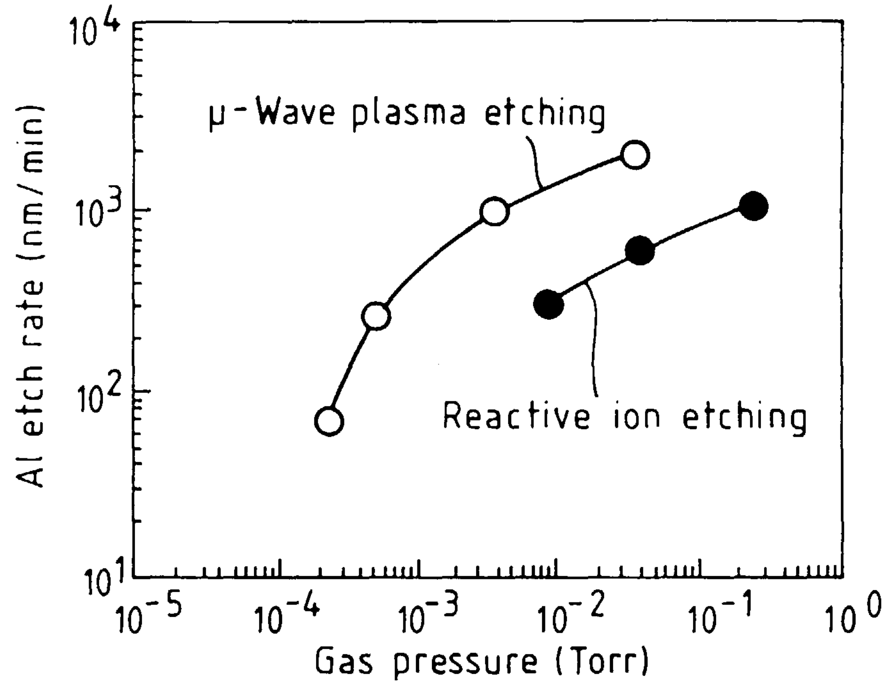

μ-Wave plasma etching
Reactive ion etching
Al etch rate (nm/min)
Gas pressure (Torr)
$10^4$
$10^3$
$10^2$
$10^1$
$10^{-5}$
$10^{-4}$
$10^{-3}$
$10^{-2}$
$10^{-1}$
$10^0$


FIG. 31

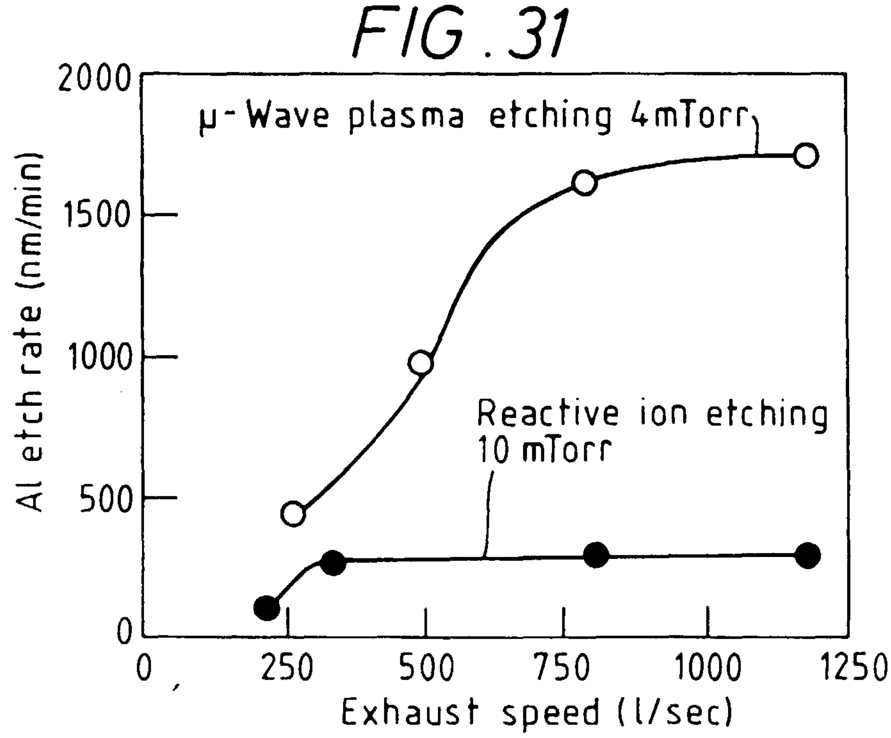

μ-Wave plasma etching 4mTorr
Reactive ion etching 10 mTorr
Al etch rate (nm/min)
Exhaust speed (l/sec)
2000
1500
1000
500
0
0
250
500
750
1000
1250

FIG.33

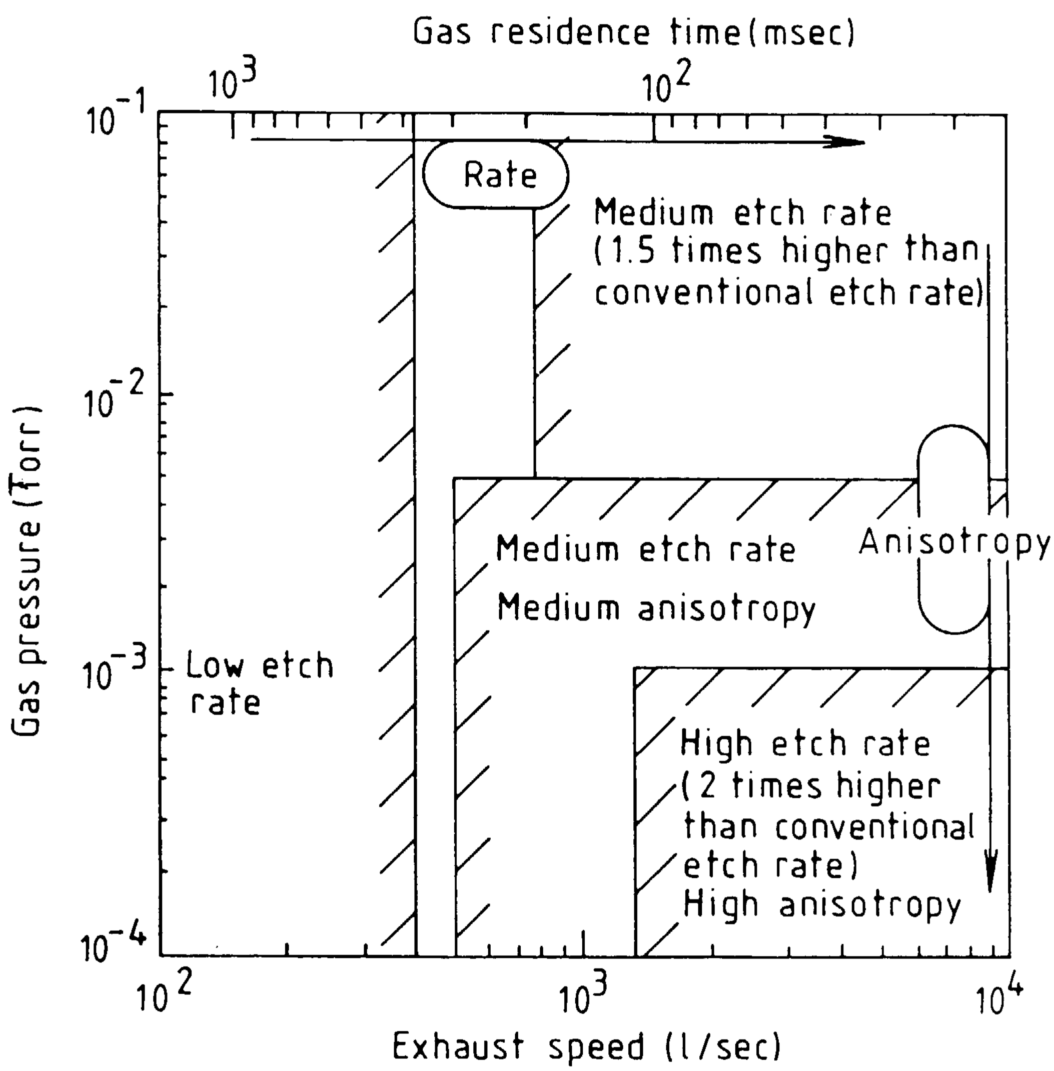
Gas residence time(msec)
$10^3$
$10^2$
$10^{-1}$
$10^{-2}$
$10^{-3}$
$10^{-4}$
Rate
Medium etch rate
(1.5 times higher than conventional etch rate)
Medium etch rate
Medium anisotropy
Anisotropy
Low etch rate
High etch rate
(2 times higher than conventional etch rate)
High anisotropy
Gas pressure (Torr)
$10^2$
$10^3$
$10^4$
Exhaust speed (l/sec)